# EUROPEAN PATENT APPLICATION

(11) **EP 4 646 057 A2**
(43) Date of publication of application: **05.11.2025**
(21) Application number: 25167240.8
(22) Date of filing: 31.03.2025
(51) Int. Cl.: H10D 84/90, G06F 30/394, H10D 88/00, H10D 89/10, H01L 23/528

(54) **ARCHITECTURES AND METHODS FOR HIGH PERFORMANCE (HP) STANDARD CELL CIRCUITS**

(30) Priority: 02.05.2024 US 202418653539
(71) Applicant: INTEL Corporation, Santa Clara, CA 95054 (US)
(72) Inventor: Arkali Radhakrishna, Nischal, Hillsboro, 97123 (US); Venkataraman, Sivakumar, Hillsboro, 97124 (US); Shi, Quan, Portland, 97229 (US); Prakash, Somashekar Bangalore, Portland, 97229 (US); Realov, Simeon Dimitrov, Portland, 97217 (US); Rajurkar, Digvijay Nitin, Beaverton, 97006 (US)
(74) Representative: Goddar, Heinz J.

(57) **Abstract**

A high performance (HP) standard cell architecture for logic cells used in a semiconductor device or product. An example semiconductor device includes a plurality of cells surrounded by a cell boundary, and a backside power delivery network (PDN) routed to the plurality of cells. At least one cell of the plurality of cells has an arrangement of transistors within the cell boundary, the arrangement of transistors coupled together to generate an output signal at an output signal node. There is a metal 0 layer above the arrangement of transistors, the metal 0 layer includes one or more input signal traces and an output signal trace. The output signal trace and the input signal traces are substantially parallel inside the cell boundary and have a first width near the cell boundary; the output signal trace has a region of a wider metal 0 inside the cell boundary.

## Description

### BACKGROUND

Standard cell height is generally reduced in every technology node to increase the number of memory or logic devices on a semiconductor chip. The horizontal metal wires and associated vias in the standard cells shrink therewith, which can result in resistance bottlenecks. Moreover, as transistors become stronger, the relative contribution of parasitic resistance from the metal wires and vias increases. Accordingly, improved architectures and methods for high performance (HP) standard cell circuits are desirable.

### BRIEF DESCRIPTION OF THE DRAWINGS

FIG. 1 is a simplified cross-sectional image of some of the fabrication layers in a wafer, for context.
FIG. 2 is a simplified illustration showing examples of the wider metal zero (M0) trace and corresponding shape, in accordance with various embodiments.
FIG. 3 is a simplified illustration showing the addition of metal one (M1) and via0 to the embodiments of FIG. 2, in accordance with various embodiments.
FIGS. 4-5 develop a first example embodiment in which the backside power delivery network is with a first via type, in accordance with various embodiments.
FIG. 6 shows a plan view of the embodiment of FIGS. 4-5 when the base layer is removed and metal 1 and via0s are added, in accordance with various embodiments. FIG.6 is also representative of the embodiment of FIGS. 7-8 with the base layer is removed and metal 1 and via0s are added.
FIGS. 7-8 develop a second example embodiment in which the backside power deliver is through a second via embodiment, in accordance with various embodiments.
FIGS. 9-12 illustrate application of the architectures described herein to a more complex standard cell, in accordance with various embodiments.
FIG. 13 is an exemplary process flow for fabrication of embodiments defined herein.
FIG. 14 is a top view of a wafer and dies that may embody integrated circuit components, in accordance with any of the embodiments disclosed herein.
FIG. 15 is a simplified cross-sectional side view showing an implementation of an integrated circuit component on a die that may be included in any of the embodiments disclosed herein.
FIG. 16 is a cross-sectional side view of a microelectronic assembly that may include any of the embodiments disclosed herein.
FIG. 17 is a block diagram of an example electrical device that may include any of the embodiments disclosed herein.

### DETAILED DESCRIPTION

Fabrication of semiconductor products with increased capacity drives the scaling of features such as transistors in integrated circuits. However, the scaling of multi-gate transistors and high-density (HD) standard cells that use them introduces technical challenges.

In a HD standard cell, the devices or transistors are generally found in a device layer. The first metal level, the metal zero (M0) layer, is adjacent to and above the device layer. The pitch of the M0 layer is generally limited by the height of the HD standard cell architecture, including the number of M0 tracks within the cell height, where a cell refers to an arrangement of one or more transistors. As the transistors/devices are reduced in size, the M0 must meet tighter spacing requirements. For any given cell height, architectures with more M0 routing tracks within the cell require tighter M0 pitch than architectures with fewer M0 tracks.

Additionally, as transistors become stronger, the relative contribution of parasitic resistance in the standard cell architecture from metal interconnects and vias increases. These factors combine to present a technical challenge of increased resistance bottlenecks in high performance (HP) standard cells.

Metal layers have a corresponding metal level in a hierarchy of device fabrication. Metal zero, Metal 0, or M0, mentioned above, refers to the first metal layer formed over a device layer. In embodiments that place metal layers over the front side of a device, M0 is the lowest metal layer, and any additional metal layers (Ml, M2, M3, etc.) are formed over the M0 layer. Metal layers comprise routing tracks, and metal lines (alternatively called metal traces, signal traces, and/or interconnect lines) are formed along the routing tracks. A given routing track may extend across a metal layer in a cell boundary, and some portions of the routing track may have metal trenches formed therein, while other portions may have an insulating material formed therein. The routing tracks or signal traces for a given metal layer are often evenly spaced and substantially parallel within the layer, the spacing between the signal traces is generally measured between the center of a first signal trace and the center of a second signal trace and referred to as a minimum pitch.

As used herein, a high performance (HP) standard cell refers to a standard cell with an output node that can drive multiple downstream capacitances, such as wire capacitances and gate fanout capacitances. Accordingly, HP standard cell architectures are especially sensitive to resistances on the output node; the output node is a signal node, it is one of several a signal nodes associated with the HP standard cell. Resistances coupled to the output node include resistances contributed by transistor or trench vias (referred to herein as "viaT"), metal zero vias (referred to herein as "via0"), and metal zero ("M0") resistance, wherein M0 refers to the lowest level metal in the trench/transistor of a gate, often a horizontal metal in top down view diagrams, described in more detail below).

The sensitivity to resistances on the output nodes increases further in HP standard cell architectures that place power delivery nodes (PDN) on the backside of the wafer, with signal nodes on the front side or upper surface of the wafer because this configuration makes the signal node or output nodes less sensitive to resistance from the PDNs.

One proposed solution "double straps" the M0, meaning implements two traces to connect M0. This improves the M0 resistance contribution by about 0.5x but that gain is less than simply using larger than minimum required size vias and traces and has the disadvantage of adding capacitance. Further, this approach may not be realistic for complex standard cell architectures with multiple input signals.

Proposed process solutions include, for example, implementing a scaled conductive barrier liner (the barrier liner is often copper, Cu). However, these process solutions involve more process steps, cost, and risk, and can introduce frequency degradation.

Embodiments provide a technical solution to this technical problem and other related enhancements, in the form of architectures and methods for high performance (HP) standard cells. As is described in more detail below, embodiments implement wider M0 track patterns with a specific shape (described below) and wider M1 straps, embodiments may also implement larger viaT and via0 sizes on output nodes. With these features, embodiments improve HP standard cell performance by reduction the HP standard cell output resistance. In a first practical example, high drive standard cells (e.g., inverters, nand and nor gates) that implement the provided architectures have shown a cell-level performance improvement of 1-1.5%, and a block-level (logic block or logic device) maximum frequency (Fmax) improvement of 0.5 to 1%. In another practical example, a 2-4% performance improvement was observed in the high drive standard cells.

The provided embodiments can be detected in various ways. Utilizing a scanning electron microscope or transmission electron microscope (TEM) can identify the standard cell layout and the M0, viaT, via0 dimensions and configurations described hereinbelow. Additionally, literature for a standard cell library can be reviewed for references to wide metal 0 and metal 1 lines and vias to improve parasitic capacitances.

The following detailed description is not intended to limit the application and use of the disclosed technologies. It may be evident that the novel embodiments can be practiced without every detail described herein. For the sake of brevity, well-known structures and devices may be shown in block diagram form to facilitate a description thereof.

Example embodiments are hereinafter described in conjunction with the following drawing figures, wherein like numerals denote like elements. Figures are not necessarily to scale but may be relied on for spatial orientation and relative positioning of features. As may be appreciated, certain terminology, such as "ceiling" and "floor", as well as "upper,", "uppermost", "lower," "above," "below," "bottom," and "top" refer to directions based on viewing the Figures to which reference is made. Further, terms such as "front," "back," "rear,", "side", "vertical", and "horizontal" may describe the orientation and/or location of portions of the component within a consistent but arbitrary frame of reference which is made clear by reference to the text and the associated Figures describing the component under discussion. Such terminology may include the words specifically mentioned above, derivatives thereof, and words of similar import.

As used herein, the term "adjacent" refers to layers or components that are in direct physical contact with each other, with no layers or components in between them. For example, a layer X that is adjacent to a layer Y refers to a layer that is in direct physical contact with layer Y. In contrast, as used herein, the phrase(s) "located on" (in the alternative, "located under," "located above/over," or "located next to," in the context of a first layer or component located on a second layer or component) includes (i) configurations in which the first layer or component is directly physically attached to the second layer (i.e., adjacent), and (ii) component and configurations in which the first layer or component is attached (e.g. coupled) to the second layer or component via one or more intervening layers or components.

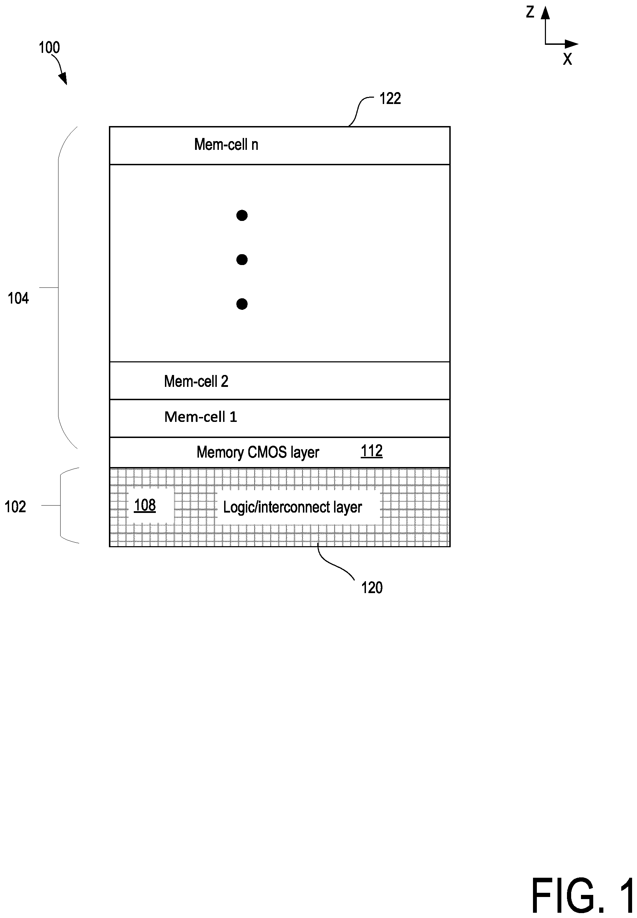

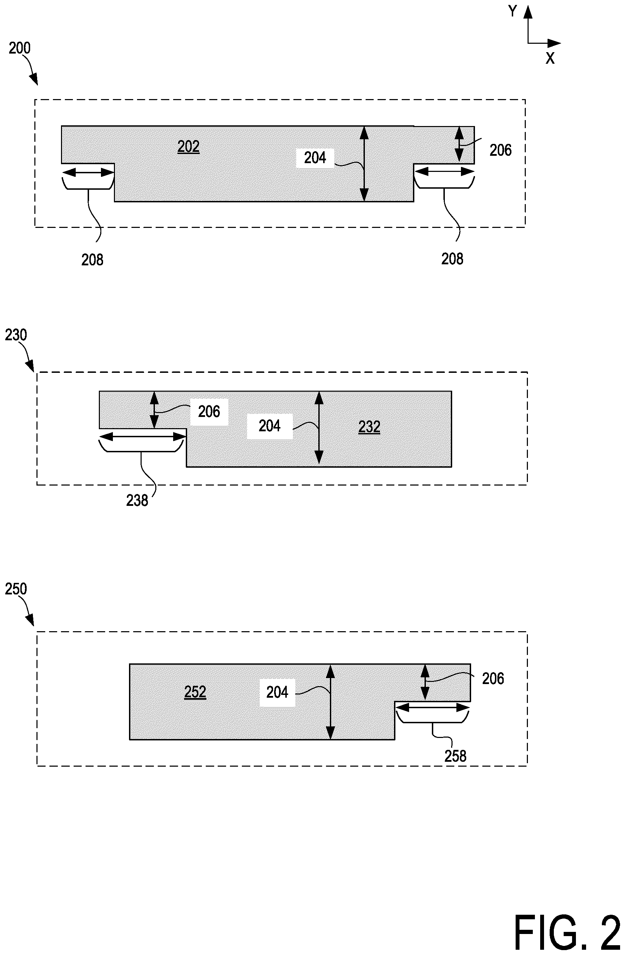

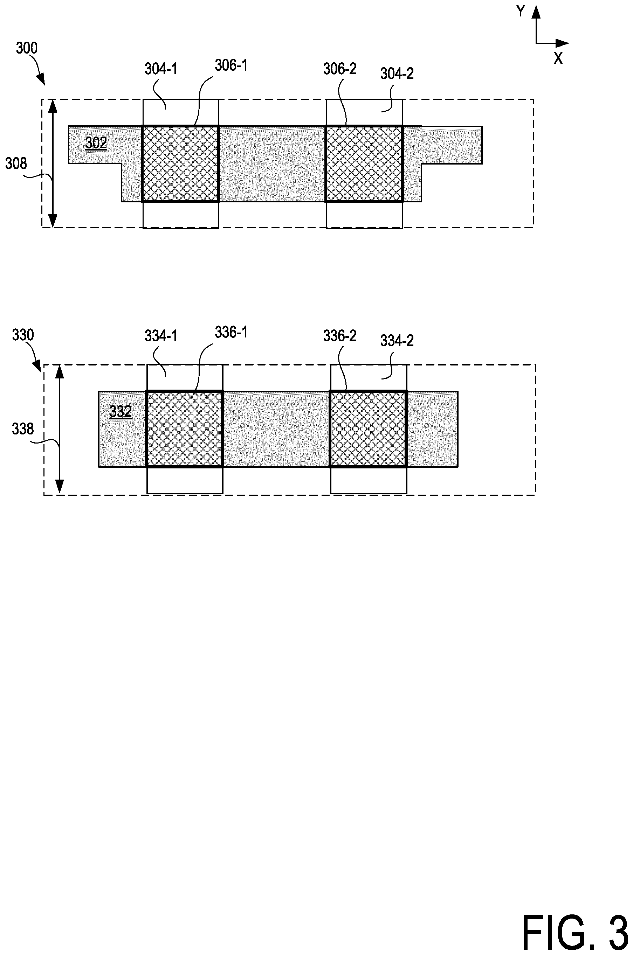

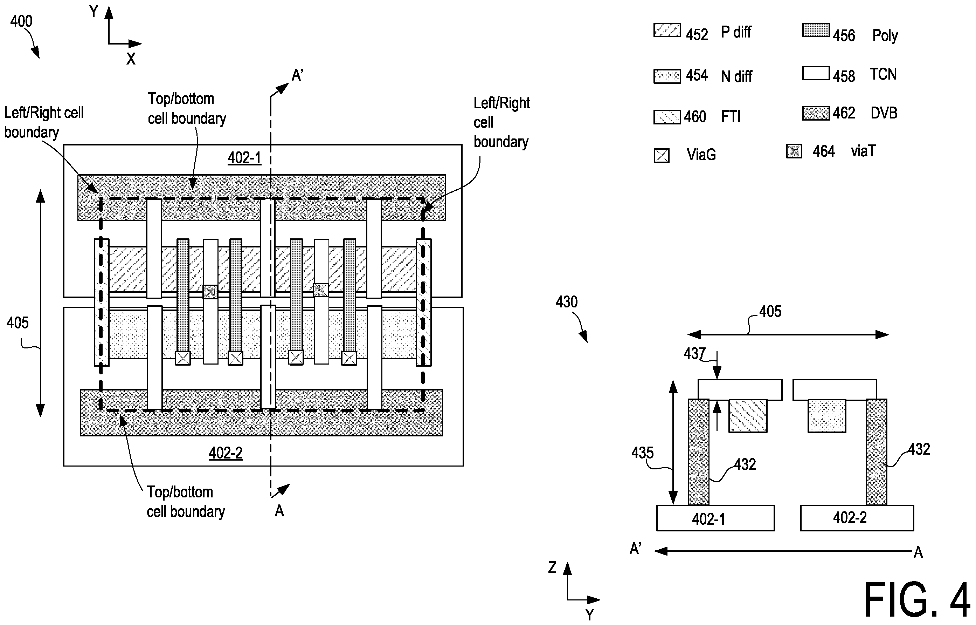

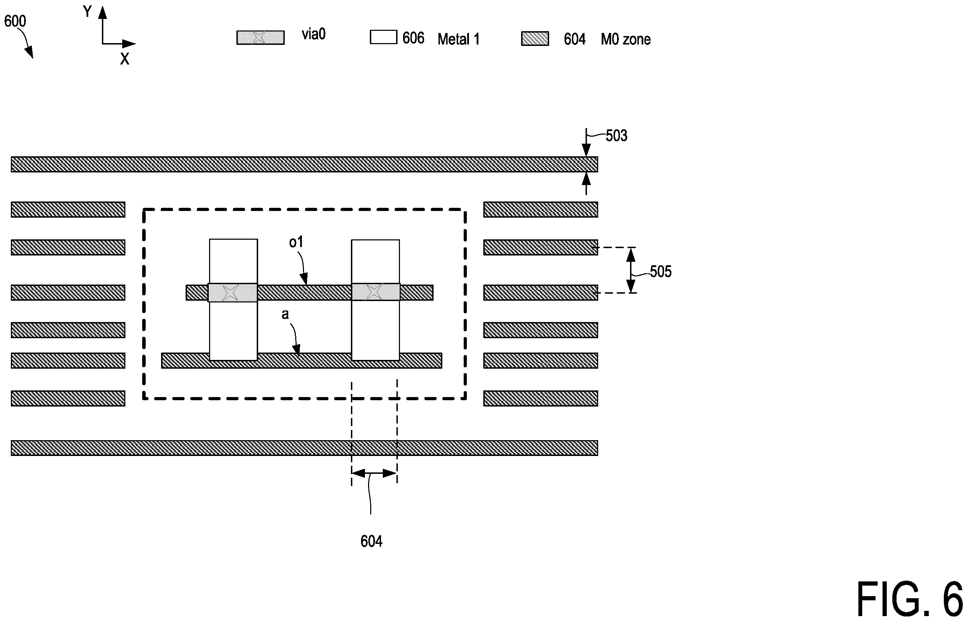

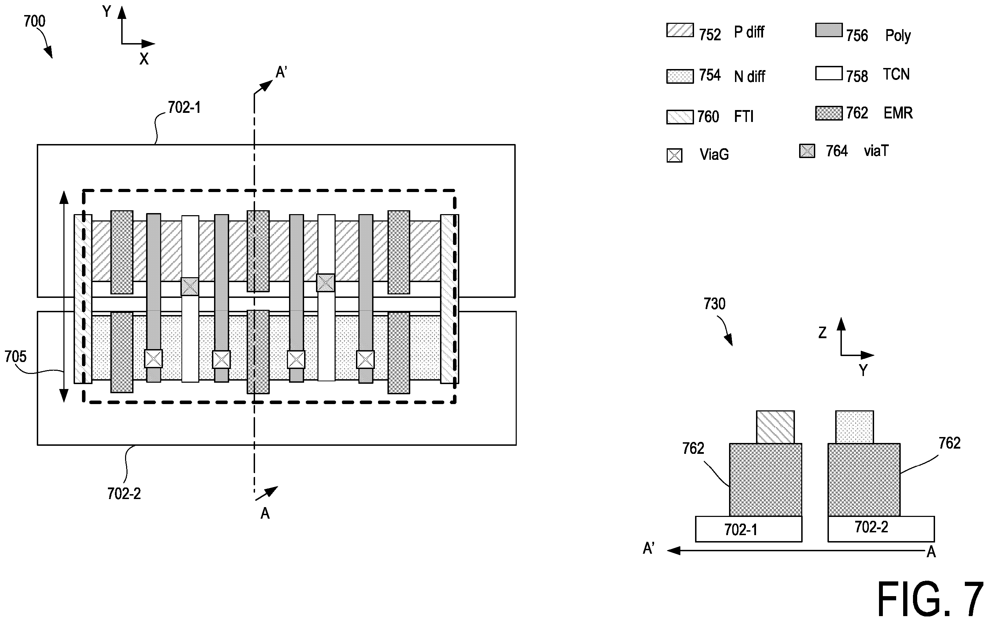

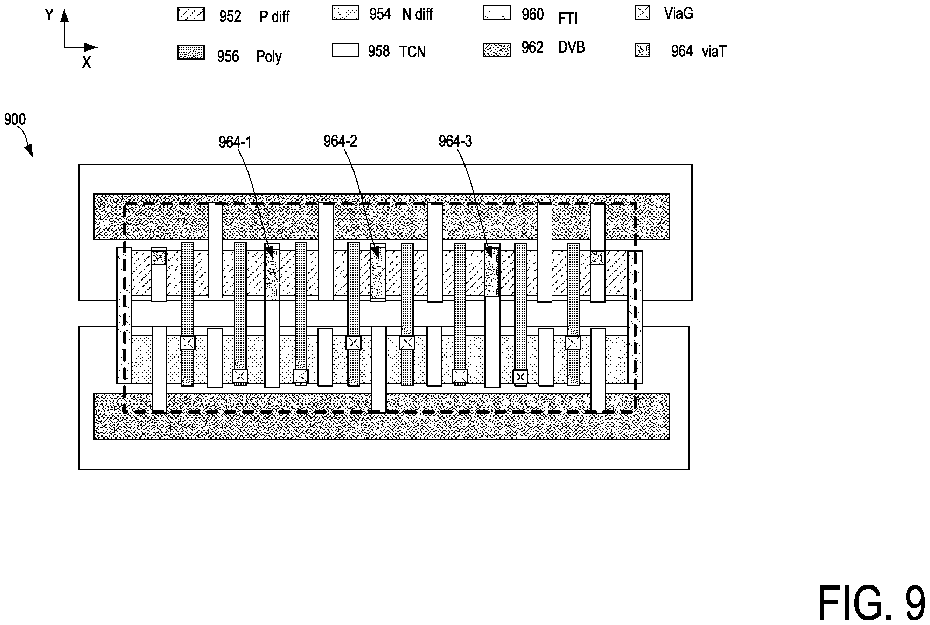

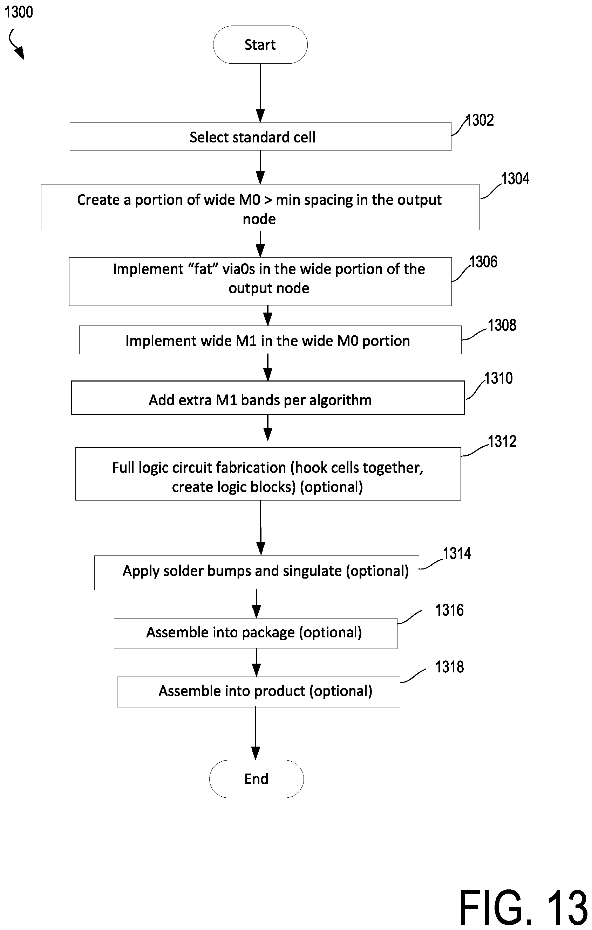

This detailed description is organized as follows. FIG. 1 is a simplified cross-sectional image 100 of some of the fabrication layers in a wafer, for context. FIG. 2 is a simplified illustration showing the wider metal zero (M0) trace and corresponding specific shape that embodiments include. FIG. 3 is a simplified illustration showing the addition of metal one (M1) and via0 to the embodiments of FIG. 2. FIGS. 4-5 develop a first example embodiment in which boundary deep vias (DVB) are used for backside power delivery network (PDN), FIG. 6 shows a plan view of the embodiment of FIGS. 4-5 when the base layer is removed and metal 1 and via0s are added. FIGS. 7-8 develop a second example embodiment in which epitaxial through emerald vias (EMR) are used for the backside power delivery network. FIG.6 is also representative of the embodiment of FIGS. 7-8 with the base layer is removed and metal 1 and via0s are added. FIGS. 9-12 illustrate embodiments of the architectures described herein, as applied to a more complex standard cell. FIG. 13 is an exemplary process flow 1300 for fabrication of embodiments defined herein. Subsequent figures provide context and potential use scenarios for embodiments described herein.

Turning now to FIG. 1, context for the embodiments is provided. The simplified wafer profile cross sectional image 100 is a non-limiting example in which provided embodiments may be implemented. In various embodiments the wafer comprises a substrate of silicon or alternative materials, which may or may not be combined with silicon, that include, but are not limited to, germanium, indium antimonide, lead telluride, indium arsenide, indium phosphide, gallium arsenide, or gallium antimonide.

The front end of line (FEOL 102) processing layers is depicted at the bottom of the wafer (bottom surface 120) and the back end of line (BEOL 104) layers are depicted toward the top of the wafer in the image 100. In various embodiments, the FEOL 102 layers may include a logic/interconnect layer 108, such as the standard cells described herein.

The BEOL 104 generally comprises a plurality of memory cell layers, denoted Mem-cell1, Mem-cell2, etc., to Mem-cell n, with Mem cell n being closest to an upper surface 122 (at the top of the image 100). The memory cell layers are separated by a dielectric material that may be referred to as BEOL substrate material to distinguish it from other dielectric materials in the wafer profile. In various embodiments, a memory CMOS layer 112 is located in between the logic/interconnect layer 108 and the first memory cell layer Mem-cell 1.

As those with skill will appreciate, the logic of the logic/interconnect layer 108 may be implemented using a variety of different architectures and/or standard cell libraries. Many cell libraries include cells with device layers comprising two-transistor heights and four M0 tracks. As the transistors grow smaller, holding the number of M0 routing tracks constant, the decreasing cell height requires tighter M0 pitch.

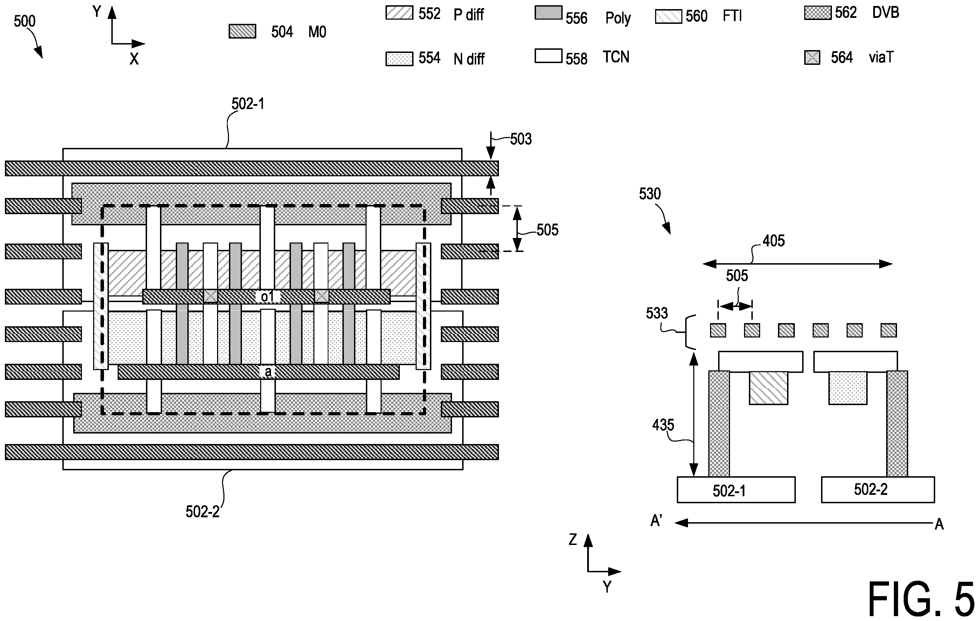

Embodiments described herein implement a backside power delivery network (PDN), which means that the power supplies (Vcc and Vss) are located on the upper surface 122 (in the figure), moreover, and as shown below (e.g., FIG. 4 and FIG. 5), these power supplies are moved directly under the individual logic cells.

The embodiments in FIG. 2 are plan views (also referred to as top-down views) of exemplary standard cells, showing a metal zero (M0) layer 202/232/252 completely inside a cell boundary indicated with a dashed line. Embodiment 200 illustrates a metal zero (M0) layer 202 with a first width 206 and a second width 204. The first width 206 may be a minimum width dictated by a process technology node. Note that the second width 204 is wider than the first width 206, and that it is in the middle of the cell boundary, not near the edges of the cell boundary. In various embodiments, the second width 204 is 1.5 times as wide (+/- 10%) as the first width 206. For example, in a given standard cell layout, there may be a defined minimum polysilicon (gate) pitch and a defined minimum M0 pitch (often these two pitches are the same); the wide M0 will be 1.5 times the defined minimum M0 pitch (+/- 10%). The wide M0 region can be observed in TEM images.

The region with the second width 204 is referred to as a "wide M0" region. While the thinner region 208/238/258 of M0, shown in embodiment 200/230/250, appears as a "tab" it is the second width 204, the wide M0 region, in the middle of the cell boundary that is the M0 variation. The wide M0 region is associated with an output signal node. The first width 206 is to match the M0 width and M0 pitch of the block-level routing that can be placed around the standard cells and used to couple them together in the synthesis of a logic device; these concepts are developed further with subsequent figures.

The transition from the first width 206 to the second width 204 is depicted as a corner of about a 90-degree angle for simplicity, however, in practice, this corner may be rounded, responsive to the processing methodology used to deposit/etch the M0 layer.

The tab has a length that can vary, so long as the corner or transition to the second width 204 occurs prior to the location for a via0, such that it is the second width at the via0 (see e.g., FIG. 3). In embodiments with the corresponding tab of the first width 206, extending outward toward the cell boundary from a location designated for a via0, the features can be observed in TEM images. Embodiment 230 and embodiment 250 are variations on the embodiment 200. In embodiment 230, the M0 layer 232 has only one tab 238 on the left in the image, and in embodiment 250, the M0 layer 252 has only one tab 258 on the right in the image.

In product teardowns, embodiments may exhibit specific features including wide M0 in the middle of the cell, narrowing to a minimum M0 width close to the left/right cell boundary (FIGS. 2-3). Embodiments may also exhibit multiple wide M1 bands (and associated wider Via0's) on nodes associated with an output signal (FIG. 3). Embodiments may exhibit wide M0 crossing the cell boundary and/or wide M0 merging with a border M0 track (usually in architectures with backside power delivery network (PDN)), these concepts are visited in more detail below.

In FIG. 3, embodiments having wide M0 are overlaid with bands of wide metal one (wide M1 304-1/334-1 and 304-2/334-2) layer. The wide M1 may be twice as wide (+/- 10%) as the width of a defined minimum M1 pitch for the standard cell. Note that the bands of wide M1 are overlaid on regions of wide M0 and extend orthogonally from a first cell boundary to an opposite cell boundary, thereby having a length 308/338. In embodiment 300, the M0 layer 302 comprises two tabs, and the wide M0 region is in between the two tabs. In embodiment 330, the M0 layer does not have any tabs.

A via0 provides a vertical electrical coupling from the M0 layer to the M1 layer. As a function of the wider M0 width and the wider M1 width, the via0 width is correspondingly wider in both the Y and X directions in the plan view, or wider in the regions with both wide M0 and wide M1, as illustrated. Accordingly, a first via0 306-1/336-1 and a second via0 306-2/336-2 are sometimes referred to as "fat."

FIG. 4 and FIG. 5 illustrate a buildup of an exemplary HP standard cell layout, which may include the above-described architecture. The image 400 is a top down or plan view, and a dashed line indicates the cell boundary. The top and bottom of the cell boundary are separated by cell width 405. The image 430 is a cross-sectional view cut through A-A', as illustrated, showing cell height or device layer 435 height. This exemplary embodiment is an inverter (as used herein, an HP standard cell layout may alternatively be referred to as simply a "standard cell layout," "cell," and architecture, depending on the discussion).

Layers include P diffusion 452/552 to form a first type of transistor, and N diffusion 454/554 to form a second type of transistor. Fin trim isolation (FTI) 460/560 provides what is sometimes referred to as "Single Diffusion Break," or a way of isolating adjacent standard cells (stdcells). Also depicted is polysilicon 456/556, trench contacts (TCN) 458/558, and trench vias represented as deep via at boundary (DVB) 462/562. In addition, ground vias (viaG) are illustrated with a white fill box and an x inside it, and trench vias (viaT 464/564) are illustrated with a grey fill box with an x inside it. A backside power delivery network (PDN) is represented with Vcc 402-1 and Vss 402-2.

The P diffusion 452 and N diffusion 454 are oriented horizontally (in image 400) near a gap between the Vcc 402-1 and the Vss 402-2, respectively; said differently, The P diffusion 452 and N diffusion 454 extend outward from a center of the cell (e.g., with the center indicated by the line A-A') and towards the left/right cell boundaries. The DVBs 462 are also oriented horizontally in image 400, extending similarly. In image 400, bands of polysilicon 456 are interleaved with bands of trench contact (TCN) in the Y direction. Ground vias (viaG) are positioned on the polysilicon 456 and trench vias are positioned on the TCN. The electrical conductivity from the backside PDN through DVB 462 and TCN 458 can be visualized in image 430.

DVB 462/562 comprises a conductive material and can be the same material as the TCN 458; both of which can also comprise layers of conductive material, or layered liners, as practiced in the art.

In a cell architecture, each of P diffusion 452 and N diffusion 454 are coupled to a respective trench contact 458 formed over the respective diffusion region, with thickness 437. Each trench contact 458 is coupled to a via 432, which couples the respective trench contact 458 to a conductive layer (e.g., Vcc 402-1 and Vss 402-2). The conductive layers associated with Vcc 402-1 and Vss 402-2 may be coupled to power circuitry not illustrated in FIG. 4 to provide the respective power supply voltages. The vias 432 are formed from a trench material, which may be any conductive material, and in this non-limiting example, they are DVBs 462. A DVB is a deep through silicon wall that connects to the trench contact TCN 458. The DVB(s) 462 extends in the y-direction in the image 400; said differently, the DVB(s) 462 extend outward from a center of the cell (e.g., with the center indicated by the line A-A') and towards the left/right cell boundaries, as shown.

As used herein, a "device layer" 435/735 includes the TCN, trench material (DVB in FIGS. 4-5 and EMR in FIGS. 7-8), and diffusion layers, when viewed in the vertical cross section of image 430/730. Image 430/730 depicts an n-type transistor and a p-type transistor in the device layer 435/735. The transistors are arranged with a source, gate, and drain extending in the X-direction or cell width direction. The diffusion regions (P diffusion 452/752 and N diffusion 454/754) may have a source and drain region formed therein, respectively. In a given standard cell, an arrangement of these p-type and n-type transistors are coupled together to generate an output on an output node that is a function of one or more inputs.

Image 500 and image 530 depict the M0 zone 504 overlaid on the device layer in the embodiment in FIG. 4, (i.e., the M0 traces are formed in a M0 layer 533 above the device layer 435 in image 430). Images 800 and 830 depict the M0 zone 504 overlaid on the device layer in the embodiment in FIG. 7, (i.e., the M0 traces are formed in a M0 layer 833 above the device layer 735 in image 730) M0 zones are included in the images to mimic M0 traces surrounding the standard cell under test (CUT). The metal 0 (M0) traces may comprise cobalt. In some embodiments, M0 may comprise copper. As mentioned above, the M0 traces in the standard cell are generally fabricated at the minimum M0 pitch 505/705, and this is the intent of the illustrations of images 500/530/700/730. In a non-limiting example, the M0 has M0 width 503/803 and the M0 pitch 505/805 may be 30 nanometers (nm) plus or minus 5 nm. The input node of this example CUT is "a" and the output node is "o1."

FIG. 6 image 600 depicts the embodiment of image 500 with the base or device layer 435 removed (to keep the image from being too busy), showing M1 and via0s added. In FIG. 6, M1 606 is white and via0s are indicated with a wide grey rectangle with a four-pointed star inside. The M1 is wide, wide M1 606 has M1 width 604, and M1 width 604 may be twice the width of the standard M1 width; the via0 is correspondingly wide (M1 width 604). Although FIGS. 7-8 depict another embodiment of a buildup of the simple inverter standard cell layout that implements a different trench via (EMR), FIG. 6 applies to FIGS. 7-8 as well.

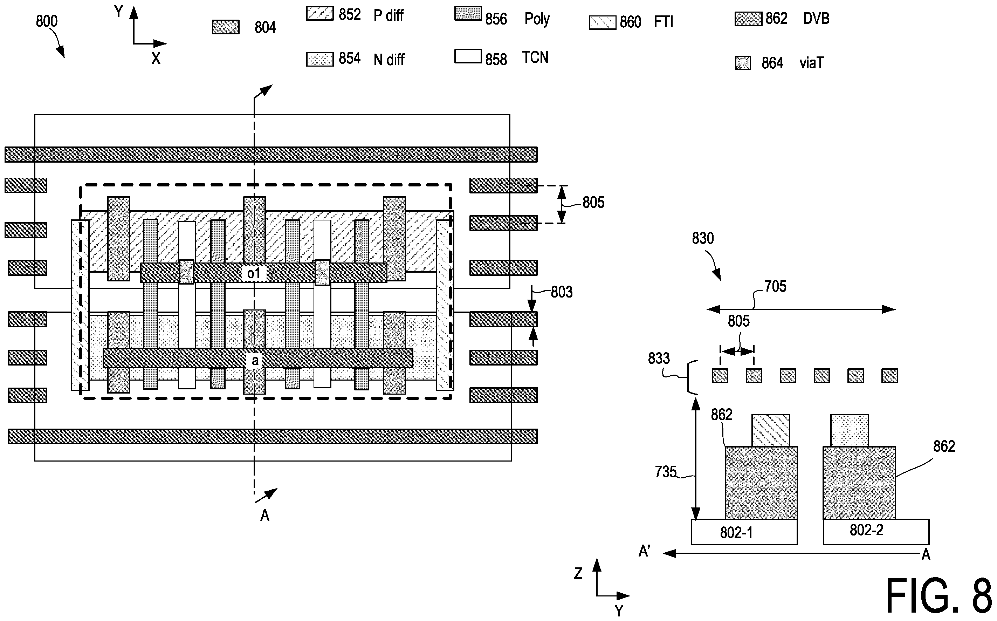

As mentioned, FIG. 7 and FIG. 8 depict another embodiment of a buildup of the simple inverter standard cell layout that implements the trench material EMR for coupling to the PDN (e.g., Vcc 802-1 and Vss 802-2). Layers include P diffusion 752/852, N diffusion 754/854, FTI 760/860, polysilicon 756/856, trench contacts (TCN) 758/858, and EMR 762/862. In addition, ground vias (viaG) are illustrated with a white fill box and an x inside it, and trench vias (viaT 764/864) are illustrated with a grey fill box with an x inside it. EMR 762/862 is a conductive material and can be the same material as the TCN 758; both of which can also comprise layers of conductive material, or layered liners, as practiced in the art.

The image 700 is a plan view and the image 730 is a cross-sectional view cut through A-A', as illustrated. A backside power delivery network (PDN) is represented with Vcc 702-1 and Vss 702-2. The P diffusion 752 and N diffusion 754 are oriented horizontally (in image 700) near a gap between the Vcc 702-1 and the Vss 702-2, respectively. Conductive EMR 762 is also oriented horizontally (in image 700). In image 700, bands of polysilicon 756 are interleaved with bands of TCN vertically. Ground vias (viaG) are positioned on the polysilicon 756 and trench vias are positioned on the TCN. The electrical conductivity from the backside PDN through EMR 762 goes directly to the P diffusion 752 and N diffusion 754, as can be visualized in image 730.

Image 800 depicts the M0 zone 804 overlaid on the embodiment in FIG. 7. As before, the M0 zones are included in the images to mimic M0 traces surrounding the standard Cell under test (CUT). The input node of this example CUT is "a" and the output node is "o1."

Returning to FIG. 6, and with continued reference to FIG. 8 image 600 also depicts the embodiment of image 800 with the base layer removed (to keep the image from being too busy), showing M1 and via0s added. Here the via0 is wide but not "fat" because M1 is wide but M0 was not.

In review of FIGS. 2-8, embodiments described so far may include the architectural features of backside PDN plus: wide M1, minimum width M0, and wide via0s; and wide M0, wide M1, and "fat" via0s.

A technical challenge is presented when a wide metal line abuts a narrow metal line (wide/narrow combination) in the direction that is parallel to the metal track, some advanced designs require that the two metal lines be separated by minimum end to end (ETE) distance in the orthogonal gate direction (OGD); this can require a plug to separate them. As used herein, "plugs" refer to a plug mask, also known as block/cut mask, which is used to create small end to end spacing (in the direction of the metal line length, e.g., horizontally in the top-down views presented for M0). While metal lines can be printed on a chip with a natural end to end spacing, without needing plug masks, the resulting spacing is usually larger than what is needed for the HD designs contemplated herein. Said differently, the plugs or block masks can be used to create any required spacing which is smaller than what can be printed naturally (https://www.ednasia.com/multi-patterning-strategies-for-navigating-the-sub-5-nm-frontier-part-1). These plugs are only used to cut minimum width lines (i.e., using a plug results in a matching minimum width M0 on each side of the plug).

The wide/narrow and wide/wide combinations of M0/M1 width described herein do not meet the minimum ETE. A possible solution is to use a different plug size than the one used to separate two metal lines which are both narrow (minimum width lines). However, a process flow may not support multiple plug sizes because doing so will increase the cost of manufacturing. The same reasoning applies for two abutting wide metal lines. As shown above, embodiments solve this technical problem with a special pattern of M0 which can be wide in the middle of the cell boundary and narrow (returning to the minimum width) at the left/right cell boundary (LRCB) to adhere to the min ETE requirement.

Turning now to FIGS. 9-11, and with continued reference to FIGS. 2-8, a more complex standard cell layout, in which the layout must meet a tight end to end (ETE) requirement, is described. In various embodiments, the ETE implies that the minimum end to end space between two neighbor or abutting M0s is less than half the M0 pitch. The example embodiment is a 4 leg/2 input NAND cell, but the architectures described herein can be applied to other standard cell logic gates as well. As before, the layers include P diffusion 952/1052, N diffusion 954/1054, FTI 960/1060, polysilicon 956/1056, trench contacts (TCN) 958/1058, and DVB 962/1062. In addition, ground vias (viaG) are illustrated with a white fill box and an x inside it, and trench vias (viaT 964/1064) are illustrated with a grey fill box with an x inside it. Although this embodiment is illustrated with DVB PDN, a similar embodiment can be created using the EMR PDN, as described above. As with the other figures, the cell boundary is indicated with a dashed line. DVB 962/1062 is a conductive material and can be the same material as the TCN 958; both of which can also comprise layers of conductive material, or layered liners, as practiced in the art.

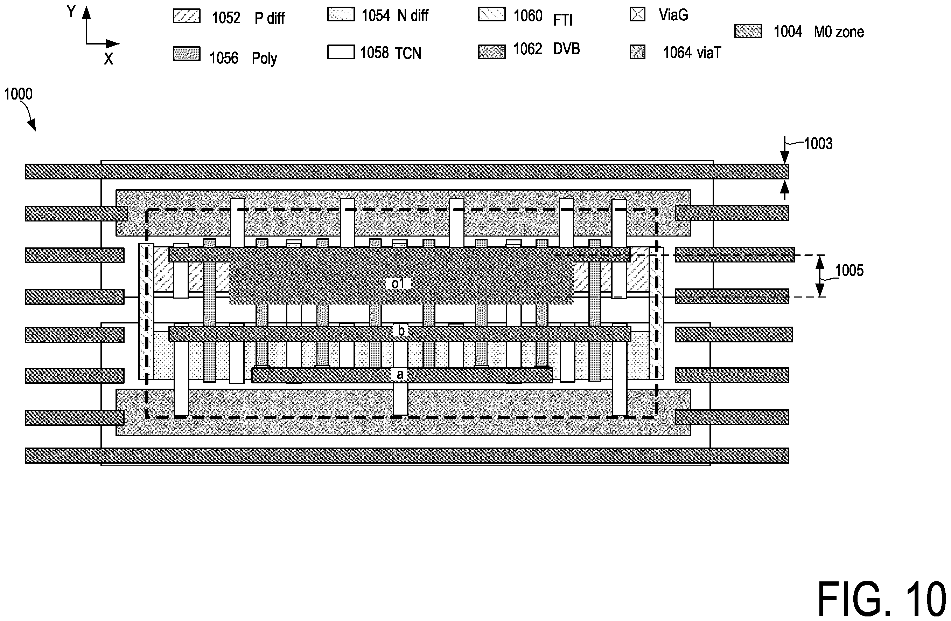

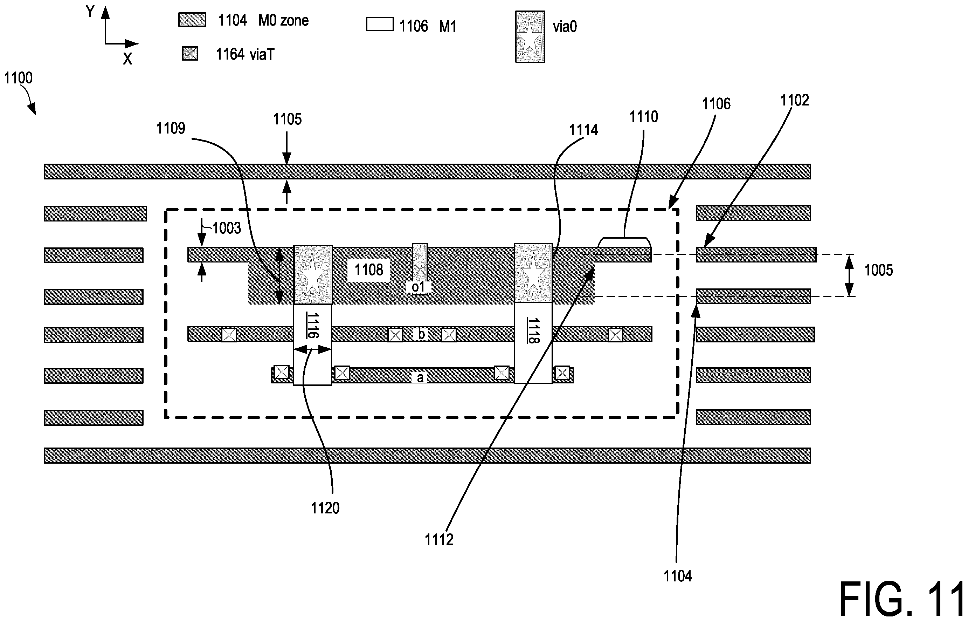

The layout objects are similar to those described in connection with FIGS. 4-5. Notable in image 900 is that the trench vias (viaTs) that couple the transistors to M0 in the middle of the cell (964-1, 964-2, 964-3) have a 1.5x length (when using the Y axis in the figure to measure length) as compared to the left-most and right-most viaT. FIG. 10 image 1000 and FIG. 11 image 1100 makes this clearer, as it illustrates the M0 zone 1004/1104 overlaid thereon. The standard M0 width 1003 and M0 pitch are indicated; the wide M0 1109 is the previously described wide in the middle, narrow or minimum width at the cell edges shape (embodiments 200 and 300).

With respect to FIG. 10, the width of the middle or wide M0 zone is configured to be greater than the minimum spacing/pitch of M0 to thereby tradeoff the output resistance (output node "o1") versus the input "b" to "o1" capacitance. Whenever current from multiple parallel transistor legs flow through a shared via, the effective electrical via resistance is higher due to current sharing. With this wide M0 in the middle strategy and architecture, the viaTs which share current from two parallel legs are upsized (this corresponds to the middle three viaTs 964-1, 964-2, and 964-3 in FIG. 9), increasing the impact from upsizing.

FIG. 11 is analogous to FIG. 6; in that it removes the base or device layer to simplify the image 1100 and depicts the addition of M1 and via0s. M1 is illustrated with solid white vertical rectangles in the FIG. 11 plan view, and via0s are illustrated with a grey box having a five-point star inside it. This figure pulls together the features described above. The M0 zone external to the cell boundary represents a block-level routing interconnect framework and comprises conductive traces or lines of M0, e.g., M0 line 1102 and M0 line 1104. The M0 lines external to the cell boundary have a minimum M0 pitch and M0 width 1105 (this corresponds to the first width 206 above). Note that the individual signal traces of the two or more signal traces shown inside the cell boundary are the same width and colinear near the cell boundary with a respective one of the block-level routing interconnects.

Inside the cell boundary, there are multiple traces of M0 that correspond to signal routing. In the example, there are two traces or lines of M0 that have the minimum M0 pitch (first width 206), those being the "a" input node and the "b" input node. The output node "o1" corresponds to/is coupled to M0 trace 1108. M0 trace 1108 comprises a portion of wide M0 (width 1109) in the middle of the cell boundary; this wide M0 transitions at a corner 1112 to a minimum M0 width tab 1110 near the cell boundary. As mentioned above, while the tab 1110 portion is depicted with a generalized width in the X direction (with the bracket), in various embodiments, it may extend all the way to the outside edge 1114 of the trench via viaT 1164. Said differently, the corner 1112 may be found at the outside edge 1114.

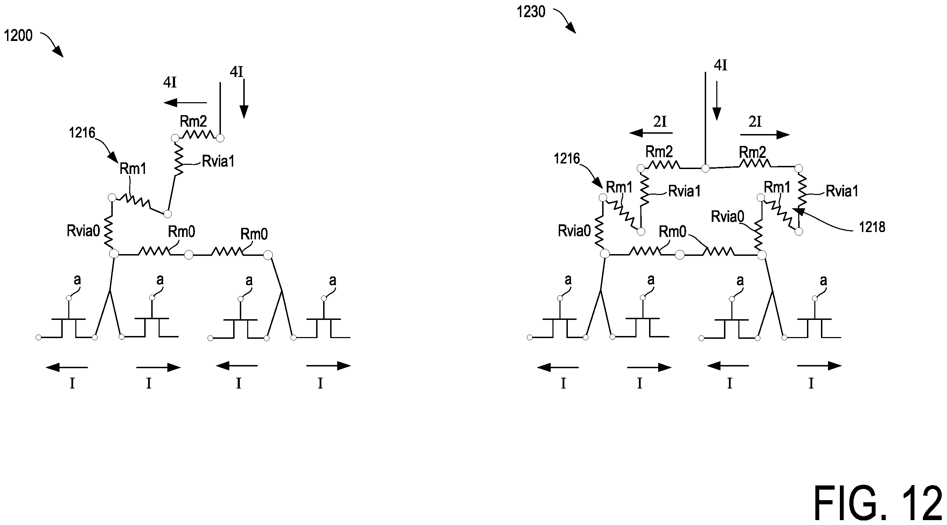

FIG. 12 is a circuit diagram 1200 corresponding to the embodiment in FIG. 11. To simplify the circuit diagram 1200, only the resistance network for M0 and above is shown, and only the NMOS transistors coupled to the output node o1 in the pull-down network of the NAND gate are shown. As illustrated, the via0 resistance (Rvia0) is more impactful on the standard cell performance as the number of parallel transistor legs ("a") increases, because all the current flowing through the parallel legs (4I) flows through the via0, resulting in higher effective electrical resistance. The four transistor legs ("a"), each with associated current "I", which flows through via0 resistance (Rvia0).

Therefore, for multi-leg HD standard cells such as this one, embodiments advantageously add multiple output M1 bands to improve (i.e., reduce) the via0 resistance. (note that the M1 bands may also be referred to as straps, traces, or lines, interchangeably) In embodiment 1230, an additional M1 band (1218) is added, with a respective second Rvai0, cutting in half the current flowing through the individual Rvia0s (2I), as shown. By adding multiple of these M1 bands with respective Via0s (also referred to herein as ViaO/M1 ports), embodiments improve the effective via0 Resistance (Rvia0). Non-limiting examples of other cells that may implement this architecture include an INV (inverter), NAN2 (two input nand gate), or NOR2 (2 input NOR gate). A non-limiting methodology or algorithm for this layout operation is, for every X fingers in parallel, add an additional M1 strap. In the illustrations in FIG. 12, X is 2.

Embodiments also designate the multiple M1 bands as block-level "must join" ports in the standard cell library. This is relevant to tools that are used to hook cells together to create logic blocks or logic devices and final semiconductor products. By implementing the "must join" ports as recommended by the embodiments, all the M1 bands can be connected by a single continuous M2 trace or line at the logic block level, which in turn adds multiple via1s in parallel, improving the effective via1 resistance Rvia1, as well as the via0 resistance.

More M2's can be connected to these M1s for higher- drive cells by placement and routing tools (e.g., via-laddering). This is depicted in embodiment 1230 by the (4I) splitting into two 2I currents that flow through a respective two M2 resistances (Rm2) and via1 resistances (Rvia1).

FIG. 13 is an exemplary process flow 1300 for fabrication of embodiments defined herein. At 1302, a standard cell layout is selected; non-limiting examples above include a four-leg inverter and a four leg NAND cell. At 1304, the process creates a portion of wide M0 by widening the M0 in the center of the cell boundary, at the output node, as described above. At 1306, the respective via0s at the output node of the cell in the portion of wide M0 are enlarged or made into "fat" via0s, to thereby extend across (or match) the width of the wide M0. At 1308, the process implements wide M1 in the portion of wide M0, as described above and as illustrated in FIGS. 6 and 11. At 1310, the process adds one or more extra M1 bands or straps in accordance with a predefined algorithm. For example, a non-limiting methodology or algorithm for this layout operation is, for every X fingers in parallel, add an additional M1 strap (in the illustrations in FIG. 12, X was 2).

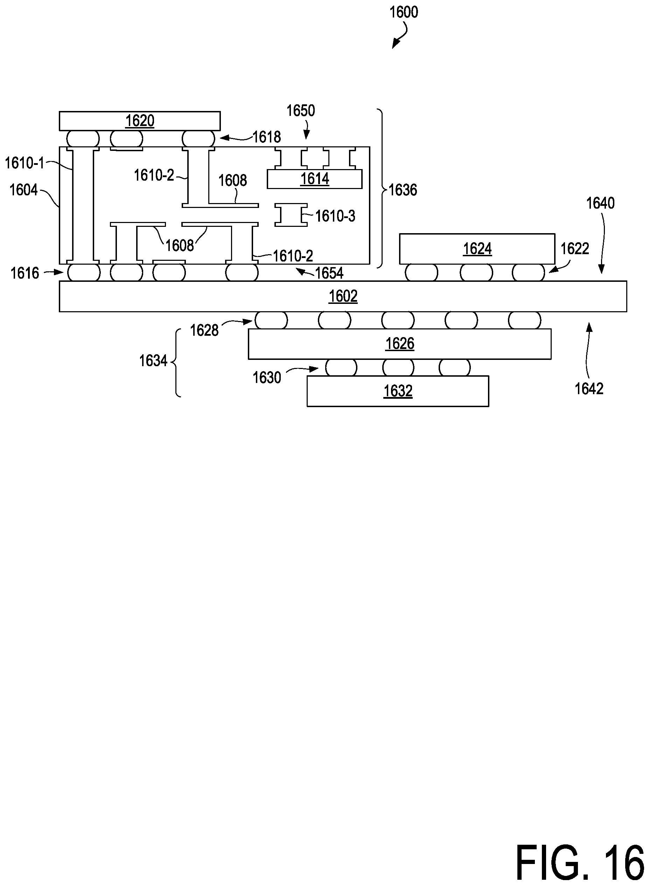

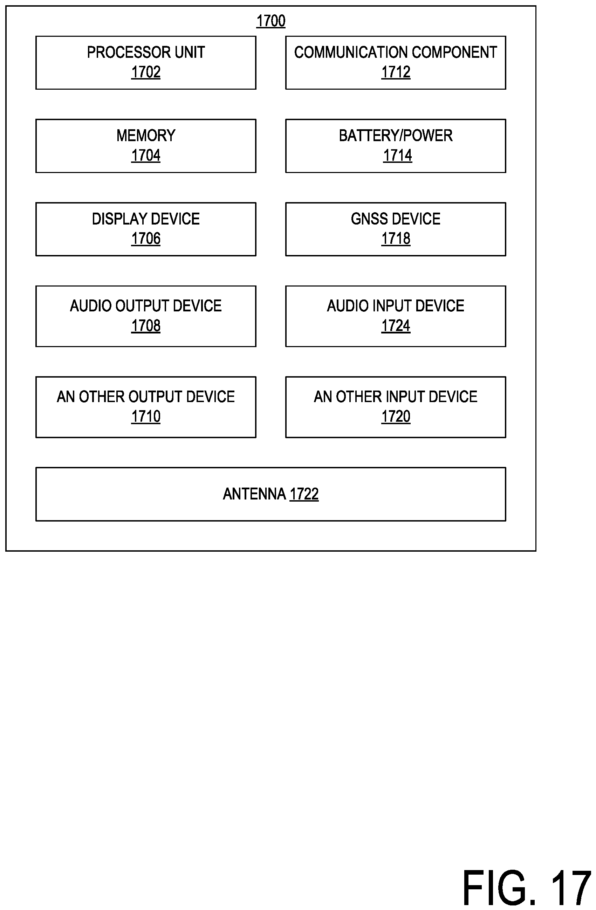

At 1312, the process optionally hooks cells together to create logic blocks/logic devices, and at 1312, the process may further hook logic blocks together with block routing to achieve full logic circuit fabrication for a semiconductor device or chip. At 1314, a wafer comprising various embodiments from 1312 may have solder bumps applied and be singulated or diced apart into individual semiconductor die. At 1318, the individual die from 1316 may be referred to as a semiconductor device and may be assembled into a package assembly. A package assembly may comprise a printed circuit board attached to an embodiment via solder bumps (e.g., see FIG. 16). In various embodiments, one or more additional integrated circuit components may be attached to the printed circuit board comprising an embodiment. The package assembly may further be assembled with a heat spreader component. A package assembly comprising one or more of the above embodiments may further be assembled into a device or product (at 1312); the device or product may further include a power supply, a communication system/component, or any of a variety of other components, as illustrated in FIG. 17.

Thus, architectures and methods for high performance standard cell circuits have been described. The following description illustrates further context for usage and application of provided embodiments.

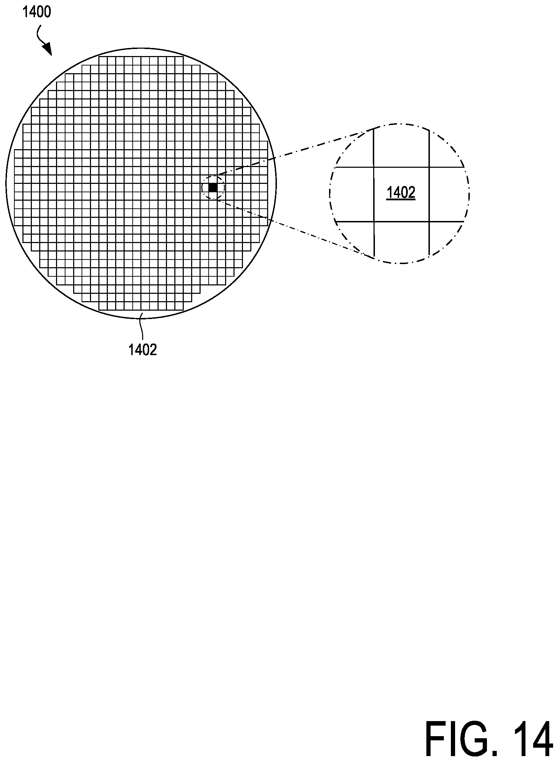

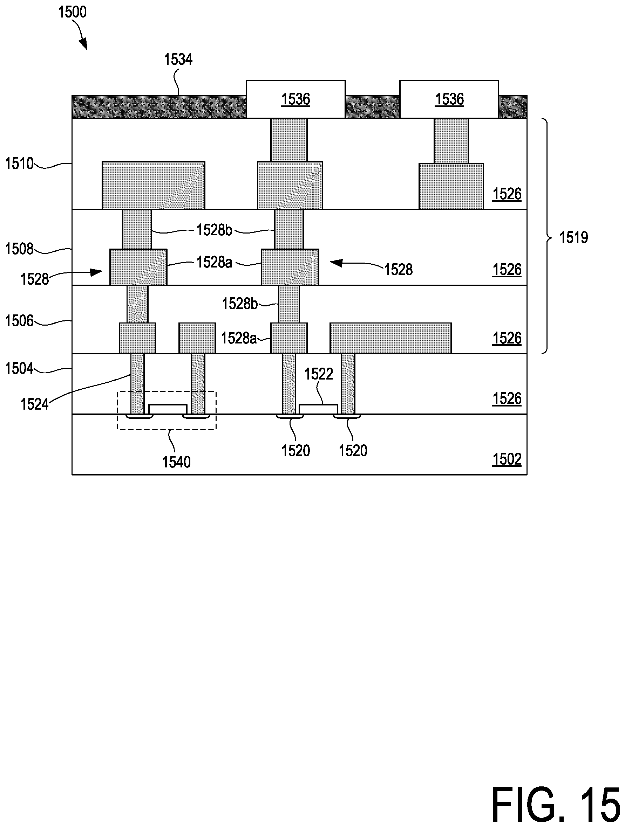

FIG. 14 is a top view of a wafer 1400 and dies 1402 that may embody integrated circuit components, in accordance with any of the embodiments disclosed herein. The wafer 1400 may be composed of semiconductor material and may include one or more die 1402 having integrated circuit structures formed on a surface of the wafer 1400. The individual circuit structures on the die 1402 may embody/implement an integrated circuit product or semiconductor product. After the fabrication of the semiconductor product is complete, the wafer 1400 may undergo a singulation process in which the die 1402 are separated from one another to provide discrete "chips" of the integrated circuit product. Respective die 1402 may be any of the die disclosed herein. The die 1402 may include one or more transistors (e.g., transistors referred to above, and/or some of the transistors 1540 of FIG. 15, discussed below), supporting circuitry to route electrical signals to the transistors, passive components (e.g., signal traces, resistors, capacitors, or inductors), and/or any other integrated circuit components.

In some embodiments, in addition to or in conjunction with the above description, the wafer 1400 or the die 1402 may include a memory device (e.g., a random access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuit element. Multiple ones of these devices may be combined on a single die 1402. For example, a memory array formed by multiple memory devices may be formed on a same die 1402 as a processor unit (e.g., the processor unit 1702 of FIG. 17) or other logic that is configured to store information in the memory devices or execute instructions stored in the memory array. Various ones of the microelectronics assemblies 1600 disclosed herein may be manufactured using a die-to-wafer assembly technique in which some dies are attached to a wafer 1400 that include others of the dies 1402, and the wafer 1400 is subsequently singulated.

FIG. 15 is a cross-sectional side view of an integrated circuit component 1500 implemented on a die that may be included in any of the that may embody integrated circuit components, in accordance with any of the embodiments disclosed herein. One or more of the integrated circuit components 1500 may be included in one or more dies 1402 (FIG. 14). The integrated circuit component 1500 may be formed on a die substrate 1502 (e.g., the wafer 1400 of FIG. 14) and may be included in a die (e.g., the die 1402 of FIG. 14). The die substrate 1502 may be a semiconductor substrate composed of semiconductor material systems including, for example, n-type or p-type materials systems (or a combination of both). The die substrate 1502 may include, for example, a crystalline substrate formed using a bulk silicon or a silicon-on-insulator (SOI) substructure. In some embodiments, the die substrate 1502 may be formed using alternative materials, which may or may not be combined with silicon, that include, but are not limited to, germanium, indium antimonide, lead telluride, indium arsenide, indium phosphide, gallium arsenide, or gallium antimonide. Further materials classified as group II-VI, III-V, or IV may also be used to form the die substrate 1502. Although a few examples of materials from which the die substrate 1502 may be formed are described here, any material that may serve as a foundation for an integrated circuit component 1500 may be used. The die substrate 1502 may be part of a singulated die (e.g., the dies 1402 of FIG. 14) or a wafer (e.g., the wafer 1400 of FIG. 14).

The integrated circuit component 1500 may include one or more device layers 1504 disposed on the die substrate 1502. The device layer 1504 may include features of one or more transistors 1540 (e.g., metal oxide semiconductor field-effect transistors (MOSFETs)) formed on the die substrate 1502. The transistors 1540 may include, for example, one or more source and/or drain (S/D) regions 1520, a gate 1522 to control current flow between the S/D regions 1520, and one or more S/D contacts 1524 to route electrical signals to/from the S/D regions 1520. The transistors 1540 may include additional features not depicted for the sake of clarity, such as device isolation regions, gate contacts, and the like. The transistors 1540 are not limited to the type and configuration depicted in FIG. 15 and may include a wide variety of other types and configurations such as, for example, planar transistors, non-planar transistors, or a combination of both. Non-planar transistors may include FinFET transistors, such as double-gate transistors or tri-gate transistors, and wrap-around or all-around gate transistors, such as nanoribbon, nanosheet, or nanowire transistors.

Continuing with FIG. 15, a transistor 1540 may include a gate 1522 formed of at least two layers, a gate dielectric and a gate electrode. The gate dielectric may include one layer or a stack of layers. The one or more layers may include silicon oxide, silicon dioxide, silicon carbide, and/or a high-k dielectric material. The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be conducted on the gate dielectric to improve its quality when a high-k material is used.

The gate electrode may be formed on the gate dielectric and may include at least one p-type work function metal or n-type work function metal, depending on whether the transistor 1540 is to be a p-type metal oxide semiconductor (PMOS) or an n-type metal oxide semiconductor (NMOS) transistor. In some implementations, the gate electrode may consist of a stack of two or more metal layers, where one or more metal layers are work function metal layers and at least one metal layer is a fill metal layer. Further metal layers may be included for other purposes, such as a barrier layer.

For a PMOS transistor, metals that may be used for the gate electrode include, but are not limited to, ruthenium, palladium, platinum, cobalt, nickel, conductive metal oxides (e.g., ruthenium oxide), and any of the metals discussed below with reference to an NMOS transistor (e.g., for work function tuning). For an NMOS transistor, metals that may be used for the gate electrode include, but are not limited to, hafnium, zirconium, titanium, tantalum, aluminum, alloys of these metals, carbides of these metals (e.g., hafnium carbide, zirconium carbide, titanium carbide, tantalum carbide, and aluminum carbide), and any of the metals discussed above with reference to a PMOS transistor (e.g., for work function tuning).

In some embodiments, when viewed as a cross-section of the transistor 1540 along the source-channel-drain direction, the gate electrode may consist of a U-shaped structure that includes a bottom portion substantially parallel to the surface of the die substrate 1502 and two sidewall portions that are substantially perpendicular to the top surface of the die substrate 1502. In other embodiments, at least one of the metal layers that form the gate electrode may simply be a planar layer that is substantially parallel to the top surface of the die substrate 1502 and does not include sidewall portions substantially perpendicular to the top surface of the die substrate 1502. In other embodiments, the gate electrode may consist of a combination of U-shaped structures and planar, non-U-shaped structures. For example, the gate electrode may consist of one or more U-shaped metal layers formed atop one or more planar, non-U-shaped layers.

In some embodiments, a pair of sidewall spacers may be formed on opposing sides of the gate stack to bracket the gate stack. The sidewall spacers may be formed from materials such as silicon nitride, silicon oxide, silicon carbide, silicon nitride doped with carbon, and silicon oxynitride. Processes for forming sidewall spacers are well known in the art and generally include deposition and etching process steps. In some embodiments, a plurality of spacer pairs may be used; for instance, two pairs, three pairs, or four pairs of sidewall spacers may be formed on opposing sides of the gate stack.

The S/D regions 1520 may be formed within the die substrate 1502 adjacent to the gate 1522 of individual transistors 1540. The S/D regions 1520 may be formed using an implantation/diffusion process or an etching/deposition process, for example. In the former process, dopants such as boron, aluminum, antimony, phosphorous, or arsenic may be ion-implanted into the die substrate 1502 to form the S/D regions 1520. An annealing process that activates the dopants and causes them to diffuse farther into the die substrate 1502 may follow the ion-implantation process. In the latter process, the die substrate 1502 may first be etched to form recesses at the locations of the S/D regions 1520. An epitaxial deposition process may then be conducted to fill the recesses with material that is used to fabricate the S/D regions 1520. In some implementations, the S/D regions 1520 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 1520 may be formed using one or more alternate semiconductor materials such as germanium or a group III-V material or alloy. In further embodiments, one or more layers of metal and/or metal alloys may be used to form the S/D regions 1520.

Electrical signals, such as power and/or input/output (I/O) signals, may be routed to and/or from the devices (e.g., transistors 1540) of the device layer 1504 through one or more interconnect layers disposed on the device layer 1504 (illustrated in FIG. 15 as interconnect layers 1506-1510). For example, electrically conductive features of the device layer 1504 (e.g., the gate 1522 and the S/D contacts 1524) may be electrically coupled with the interconnect structures 1528 of the interconnect layers 1506-1510. The one or more interconnect layers 1506-1510 may form a metallization stack (also referred to as an "ILD stack") 1519 of the integrated circuit component 1500.

The interconnect structures 1528 may be arranged within the interconnect layers 1506-1510 to route electrical signals according to a wide variety of designs; in particular, the arrangement is not limited to the particular configuration of interconnect structures 1528 depicted in FIG. 15. Although a particular number of interconnect layers 1506-1510 is depicted in FIG. 15, embodiments of the present disclosure include integrated circuit components having more or fewer interconnect layers than depicted.

In some embodiments, the interconnect structures 1528 may include lines 1528a and/or vias 1528b filled with an electrically conductive material such as a metal. The lines 1528a may be arranged to route electrical signals in a direction of a plane that is substantially parallel with a surface of the die substrate 1502 upon which the device layer 1504 is formed. For example, the lines 1528a may route electrical signals in a direction in and out of the page and/or in a direction across the page. The vias 1528b may be arranged to route electrical signals in a direction of a plane that is substantially perpendicular to the surface of the die substrate 1502 upon which the device layer 1504 is formed. In some embodiments, the vias 1528b may electrically couple lines 1528a of different interconnect layers 1506-1510 together.

The interconnect layers 1506-1510 may include a dielectric material 1526 disposed between the interconnect structures 1528, as shown in FIG. 15. In some embodiments, dielectric material 1526 disposed between the interconnect structures 1528 in different ones of the interconnect layers 1506-1510 may have different compositions; in other embodiments, the composition of the dielectric material 1526 between different interconnect layers 1506-1510 may be the same. The device layer 1504 may include a dielectric material 1526 disposed between the transistors 1540 and a bottom layer of the metallization stack as well. The dielectric material 1526 included in the device layer 1504 may have a different composition than the dielectric material 1526 included in the interconnect layers 1506-1510; in other embodiments, the composition of the dielectric material 1526 in the device layer 1504 may be the same as a dielectric material 1526 included in any one of the interconnect layers 1506-1510.

A first interconnect layer 1506 (referred to as Metal 1 or "M1") may be formed directly on the device layer 1504. In some embodiments, the first interconnect layer 1506 may include lines 1528a and/or vias 1528b, as shown. The lines 1528a of the first interconnect layer 1506 may be coupled with contacts (e.g., the S/D contacts 1524) of the device layer 1504. The vias 1528b of the first interconnect layer 1506 may be coupled with the lines 1528a of a second interconnect layer 1508.

The second interconnect layer 1508 (referred to as Metal 2 or "M2") may be formed directly on the first interconnect layer 1506. In some embodiments, the second interconnect layer 1508 may include via 1528b to couple the lines that are interconnect structures 1528 of the second interconnect layer 1508 with the lines 1528a of a third interconnect layer 1510. Although the lines 1528a and the vias 1528b are structurally delineated with a line within individual interconnect layers for the sake of clarity, the lines 1528a and the vias 1528b may be structurally and/or materially contiguous (e.g., simultaneously filled during a dual-damascene process) in some embodiments.

The third interconnect layer 1510 (referred to as Metal 3 or "M3") (and additional interconnect layers, as desired) may be formed in succession on the second interconnect layer 1508 according to similar techniques and configurations described in connection with the second interconnect layer 1508 or the first interconnect layer 1506. In some embodiments, the interconnect layers that are "higher up" in the metallization stack 1519 in the integrated circuit component 1500 (i.e., farther away from the device layer 1504) may be thicker that the interconnect layers that are lower in the metallization stack 1519, with lines 1528a and vias 1528b in the higher interconnect layers being thicker than those in the lower interconnect layers.

The integrated circuit component 1500 may include a solder resist material 1534 (e.g., polyimide or similar material) and one or more conductive contacts 1536 formed on the interconnect layers 1506-1510. In FIG. 15, the conductive contacts 1536 are illustrated as taking the form of bond pads. The conductive contacts 1536 may be electrically coupled with the interconnect structures 1528 and configured to route the electrical signals of the transistor(s) 1540 to external devices. For example, solder bonds may be formed on the one or more conductive contacts 1536 to mechanically and/or electrically couple an integrated circuit die including the integrated circuit component 1500 with another component (e.g., a printed circuit board). The integrated circuit component 1500 may include additional or alternate structures to route the electrical signals from the interconnect layers 1506-1510; for example, the conductive contacts 1536 may include other analogous features (e.g., posts) that route the electrical signals to external components.

In some embodiments in which the integrated circuit component 1500 is double-sided (e.g., 902, FIG. 9), the integrated circuit component 1500 may include another metallization stack (not shown) on the opposite side of the device layer(s) 1504. This metallization stack may include multiple interconnect layers as discussed above with reference to the interconnect layers 1506-1510, to provide conductive pathways (e.g., including conductive lines and vias) between the device layer(s) 1504 and additional conductive contacts (not shown) on the opposite side of the integrated circuit component 1500 from the conductive contacts 1536.

In other embodiments in which the integrated circuit component 1500 is a double-sided, the integrated circuit component 1500 may include one or more through silicon vias (TSVs) through the die substrate 1502; these TSVs may make contact with the device layer(s) 1504, and may provide conductive pathways between the device layer(s) 1504 and additional conductive contacts (not shown) on the opposite side of the integrated circuit component 1500 from the conductive contacts 1536. In some embodiments, TSVs extending through the substrate can be used for routing power and ground signals from conductive contacts on the opposite side of the integrated circuit component 1500 from the conductive contacts 1536 to the transistors 1540 and any other components integrated into the die of the integrated circuit component 1500, and the metallization stack 1519 can be used to route I/O signals from the conductive contacts 1536 to transistors 1540 and any other components integrated into the die of the integrated circuit component 1500.

Multiple integrated circuit components 1500 may be stacked with one or more TSVs in the individual stacked devices providing connection between one of the devices to any of the other devices in the stack. For example, one or more high-bandwidth memory (HBM) integrated circuit dies can be stacked on top of a base integrated circuit die and TSVs in the HBM dies can provide connection between the individual HBM and the base integrated circuit die. Conductive contacts can provide additional connections between adjacent integrated circuit dies in the stack. In some embodiments, the conductive contacts can be fine-pitch solder bumps (microbumps).

FIG. 16 is a cross-sectional side view of a "package assembly" or microelectronics assembly 1600 that may include an apparatus or structure disclosed herein. The microelectronics assembly 1600 includes a number of components disposed on a circuit board 1602 (which may be a motherboard, system board, mainboard, etc.). The microelectronics assembly 1600 includes components disposed on a first face 1640 of the circuit board 1602 and an opposing second face 1642 of the circuit board 1602; generally, components may be disposed on one or both faces 1640 and 1642.

In some embodiments, the circuit board 1602 may be a printed circuit board (PCB) including multiple metal (or interconnect) layers separated from one another by layers of dielectric material and interconnected by electrically conductive vias. The individual metal layers comprise conductive traces. Any one or more of the metal layers may be formed in a desired circuit pattern to route electrical signals (optionally in conjunction with other metal layers) between the components coupled to the circuit board 1602. In other embodiments, the circuit board 1602 may be a non-PCB substrate. In some embodiments the circuit board 1602 may be, for example PCB. The microelectronics assembly 1600 illustrated in FIG. 16 includes a package-on-interposer structure 1636 coupled to the first face 1640 of the circuit board 1602 by coupling components 1616. The coupling components 1616 may electrically and mechanically couple the package-on-interposer structure 1636 to the circuit board 1602, and may include solder balls (as shown in FIG. 16), pins (e.g., as part of a pin grid array (PGA), contacts (e.g., as part of a land grid array (LGA)), male and female portions of a socket, an adhesive, an underfill material, and/or any other suitable electrical and/or mechanical coupling structure. The coupling components 1616 may serve as the coupling components illustrated or described for any of the substrate assembly or substrate assembly components described herein, as appropriate.

The package-on-interposer structure 1636 may include an integrated circuit component 1620 coupled to an interposer 1604 by coupling components 1618. The coupling components 1618 may take any suitable form for the application, such as the forms discussed above with reference to the coupling components 1616. Although a single integrated circuit component 1620 is shown in FIG. 16, multiple integrated circuit components may be coupled to the interposer 1604; indeed, additional interposers may be coupled to the interposer 1604. The interposer 1604 may provide an intervening substrate used to bridge the circuit board 1602 and the integrated circuit component 1620.

The integrated circuit component 1620 may be a packaged or unpacked integrated circuit product that includes one or more integrated circuit dies (e.g., the die 1402 of FIG. 14, the integrated circuit component 1500 of FIG. 15) and/or one or more other suitable components. A packaged integrated circuit component comprises one or more integrated circuit dies mounted on a package substrate with the integrated circuit dies and package substrate encapsulated in a casing material, such as a metal, plastic, glass, or ceramic. In one example of an unpackaged integrated circuit component 1620, a single monolithic integrated circuit die comprises solder bumps attached to contacts on the die. The solder bumps allow the die to be directly attached to the interposer 1604. The integrated circuit component 1620 can comprise one or more computing system components, such as one or more processor units (e.g., system-on-a-chip (SoC), processor core, graphics processor unit (GPU), accelerator, chipset processor), I/O controller, memory, or network interface controller. In some embodiments, the integrated circuit component 1620 can comprise one or more additional active or passive devices such as capacitors, decoupling capacitors, resistors, inductors, fuses, diodes, transformers, sensors, electrostatic discharge (ESD) devices, and memory devices.

In embodiments where the integrated circuit component 1620 comprises multiple integrated circuit die, they dies can be of the same type (a homogeneous multi-die integrated circuit component) or of two or more different types (a heterogeneous multi-die integrated circuit component). A multi-die integrated circuit component can be referred to as a multi-chip package (MCP) or multi-chip module (MCM).

In addition to comprising one or more processor units, the integrated circuit component 1620 can comprise additional components, such as embedded DRAM, stacked high bandwidth memory (HBM), shared cache memories, input/output (I/O) controllers, or memory controllers. Any of these additional components can be located on the same integrated circuit die as a processor unit, or on one or more integrated circuit dies separate from the integrated circuit dies comprising the processor units. These separate integrated circuit dies can be referred to as "chiplets". In embodiments where an integrated circuit component comprises multiple integrated circuit dies, interconnections between dies can be provided by the package substrate, one or more silicon interposers, one or more silicon bridges embedded in the package substrate (such as Intel^{®} embedded multi-die interconnect bridges (EMIBs)), or combinations thereof.

Generally, the interposer 1604 may spread connections to a wider pitch or reroute a connection to a different connection. For example, the interposer 1604 may couple the integrated circuit component 1620 to a set of ball grid array (BGA) conductive contacts of the coupling components 1616 for coupling to the circuit board 1602. In the embodiment illustrated in FIG. 16, the integrated circuit component 1620 and the circuit board 1602 are attached to opposing sides of the interposer 1604; in other embodiments, the integrated circuit component 1620 and the circuit board 1602 may be attached to a same side of the interposer 1604. In some embodiments, three or more components may be interconnected by way of the interposer 1604.

In some embodiments, the interposer 1604 may be formed as a PCB, including multiple metal layers separated from one another by layers of dielectric material and interconnected by electrically conductive vias. In some embodiments, the interposer 1604 may be formed of an epoxy resin, a fiberglass-reinforced epoxy resin, an epoxy resin with inorganic fillers, a ceramic material, or a polymer material such as polyimide. In some embodiments, the interposer 1604 may be formed of alternate rigid or flexible materials that may include the same materials described above for use in a semiconductor substrate, such as silicon, germanium, and other group III-V and group IV materials. The interposer 1604 may include metal interconnects 1608 and vias 1610, including but not limited to through hole vias 1610-1 (that extend from a first face 1650 of the interposer 1604 to a second face 1654 of the interposer 1604), blind vias 1610-2 (that extend from the first or second faces 1650 or 1654 of the interposer 1604 to an internal metal layer), and buried vias 1610-3 (that connect internal metal layers).

In some embodiments, the interposer 1604 can comprise a silicon interposer. Through silicon vias (TSV) extending through the silicon interposer can connect connections on the first face of a silicon interposer to an opposing second face of the silicon interposer. In some embodiments, an interposer 1604 comprising a silicon interposer can further comprise one or more routing layers to route connections on a first face of the interposer 1604 to an opposing second face of the interposer 1604.

The interposer 1604 may further include embedded devices 1614, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency devices, power amplifiers, power management devices, antennas, arrays, sensors, and microelectromechanical systems (MEMS) devices may also be formed on the interposer 1604. The package-on-interposer structure 1636 may take the form of any of the package-on-interposer structures known in the art. In embodiments where the interposer is a non-printed circuit board

The microelectronics assembly 1600 may include an integrated circuit component 1624 coupled to the first face 1640 of the circuit board 1602 by coupling components 1622. The coupling components 1622 may take the form of any of the embodiments discussed above with reference to the coupling components 1616, and the integrated circuit component 1624 may take the form of any of the embodiments discussed above with reference to the integrated circuit component 1620.

The microelectronics assembly 1600 illustrated in FIG. 16 includes a package-on-package structure 1634 coupled to the second face 1642 of the circuit board 1602 by coupling components 1628. The package-on-package structure 1634 may include an integrated circuit component 1626 and an integrated circuit component 1632 coupled together by coupling components 1630 such that the integrated circuit component 1626 is disposed between the circuit board 1602 and the integrated circuit component 1632. The coupling components 1628 and 1630 may take the form of any of the embodiments of the coupling components 1616 discussed above, and the integrated circuit components 1626 and 1632 may take the form of any of the embodiments of the integrated circuit component 1620 discussed above. The package-on-package structure 1634 may be configured in accordance with any of the package-on-package structures known in the art.

FIG. 17 is a block diagram of an example electrical device 1700 or final product that may include an apparatus and/or structure disclosed herein. For example, any suitable ones of the components of the electrical device 1700 may include one or more of the apparatus, structures, microelectronic assemblies 1600, integrated circuit components, or integrated circuit dies 1402 disclosed herein. A number of components are illustrated in FIG. 17 as included in the electrical device 1700, but any one or more of these components may be omitted or duplicated, as suitable for the application. In some embodiments, some or all the components included in the electrical device 1700 may be attached to one or more motherboards mainboards, or system boards. In some embodiments, one or more of these components are fabricated onto a single system-on-a-chip (SoC) die. In some embodiments, some or all of the components included in the electrical device 1700 may be enclosed in a housing 1726.

Additionally, in various embodiments, the electrical device 1700 may not include one or more of the components illustrated in FIG. 17, but the electrical device 1700 may include interface circuitry for coupling to the one or more components. For example, the electrical device 1700 may not include a display device 1706, but may include display device interface circuitry (e.g., a connector and driver circuitry) to which a display device 1706 may be coupled. In another set of examples, the electrical device 1700 may not include an audio input device 1724 or an audio output device 1708, but may include audio input or output device interface circuitry (e.g., connectors and supporting circuitry) to which an audio input device 1724 or audio output device 1708 may be coupled.

The electrical device 1700 may include one or more processor units 1702, as defined herein. The electrical device 1700 may include a memory 1704, which may itself include one or more memory devices such as volatile memory (e.g., dynamic random access memory (DRAM), static random-access memory (SRAM)), non-volatile memory (e.g., read-only memory (ROM), flash memory, chalcogenide-based phase-change non-voltage memories), solid state memory, and/or a hard drive. In some embodiments, the memory 1704 may include memory that is located on the same integrated circuit die as the processor unit 1702. This memory may be used as cache memory (e.g., Level 1 (L1), Level 2 (L2), Level 3 (L3), Level 4 (L4), Last Level Cache (LLC)) and may include embedded dynamic random-access memory (eDRAM) or spin transfer torque magnetic random-access memory (STT-MRAM).

In some embodiments, the electrical device 1700 can comprise one or more processor units 1702 that are heterogeneous or asymmetric to another processor unit 1702 in the electrical device 1700. There can be a variety of differences between the processing units 1702 in a system in terms of a spectrum of metrics of merit including architectural, microarchitectural, thermal, power consumption characteristics, and the like. These differences can effectively manifest themselves as asymmetry and heterogeneity among the processor units 1702 in the electrical device 1700.

In some embodiments, the electrical device 1700 may include a communication component 1712 (e.g., one or more communication components). For example, the communication component 1712 can manage wireless communications for the transfer of data to and from the electrical device 1700. The term "wireless" and its derivatives may be used to describe circuits, devices, systems, methods, techniques, communications channels, etc., that may communicate data using modulated electromagnetic radiation through a nonsolid medium. The term "wireless" does not imply that the associated devices do not contain any wires, although in some embodiments they might not.

The communication component 1712 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra-mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication component 1712 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication component 1712 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication component 1712 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication component 1712 may operate in accordance with other wireless protocols in other embodiments. The electrical device 1700 may include an antenna 1722 to facilitate wireless communications and/or to receive other wireless communications (such as AM or FM radio transmissions).

In some embodiments, the communication component 1712 may manage wired communications, such as electrical, optical, or any other suitable communication protocols (e.g., IEEE 802.3 Ethernet standards). As noted above, the communication component 1712 may include multiple communication components. For instance, a first communication component 1712 may be dedicated to shorter-range wireless communications such as Wi-Fi or Bluetooth, and a second communication component 1712 may be dedicated to longer-range wireless communications such as global positioning system (GPS), EDGE, GPRS, CDMA, WiMAX, LTE, EV-DO, or others. In some embodiments, a first communication component 1712 may be dedicated to wireless communications, and a second communication component 1712 may be dedicated to wired communications.

The electrical device 1700 may include battery/power circuitry 1714. The battery/power circuitry 1714 may include one or more energy storage devices (e.g., batteries or capacitors) and/or circuitry for coupling components of the electrical device 1700 to an energy source separate from the electrical device 1700 (e.g., AC line power).

The electrical device 1700 may include a display device 1706 (or corresponding interface circuitry, as discussed above). The display device 1706 may include one or more embedded or wired or wirelessly connected external visual indicators, such as a heads-up display, a computer monitor, a projector, a touchscreen display, a liquid crystal display (LCD), a light-emitting diode display, or a flat panel display.

The electrical device 1700 may include an audio output device 1708 (or corresponding interface circuitry, as discussed above). The audio output device 1708 may include any embedded or wired or wirelessly connected external device that generates an audible indicator, such speakers, headsets, or earbuds.

The electrical device 1700 may include an audio input device 1724 (or corresponding interface circuitry, as discussed above). The audio input device 1724 may include any embedded or wired or wirelessly connected device that generates a signal representative of a sound, such as microphones, microphone arrays, or digital instruments (e.g., instruments having a musical instrument digital interface (MIDI) output). The electrical device 1700 may include a Global Navigation Satellite System (GNSS) device 1718 (or corresponding interface circuitry, as discussed above), such as a Global Positioning System (GPS) device. The GNSS device 1718 may be in communication with a satellite-based system and may determine a geolocation of the electrical device 1700 based on information received from one or more GNSS satellites, as known in the art.

The electrical device 1700 may include another output device 1710 (or corresponding interface circuitry, as discussed above). Examples of the other output device 1710 may include an audio codec, a video codec, a printer, a wired or wireless transmitter for providing information to other devices, or an additional storage device.

The electrical device 1700 may include another input device 1720 (or corresponding interface circuitry, as discussed above). Examples of the other input device 1720 may include an accelerometer, a gyroscope, a compass, an image capture device (e.g., monoscopic or stereoscopic camera), a trackball, a trackpad, a touchpad, a keyboard, a cursor control device such as a mouse, a stylus, a touchscreen, proximity sensor, microphone, a bar code reader, a Quick Response (QR) code reader, electrocardiogram (ECG) sensor, PPG (photoplethysmogram) sensor, galvanic skin response sensor, any other sensor, or a radio frequency identification (RFID) reader.

The electrical device 1700 may have any desired form factor, such as a hand-held or mobile electrical device (e.g., a cell phone, a smart phone, a mobile internet device, a music player, a tablet computer, a laptop computer, a 2-in-1 convertible computer, a portable all-in-one computer, a netbook computer, an Ultrabook computer, a personal digital assistant (PDA), an ultra-mobile personal computer, a portable gaming console, etc.), a desktop electrical device, a server, a rack-level computing solution (e.g., blade, tray or sled computing systems), a workstation or other networked computing component, a printer, a scanner, a monitor, a set-top box, an entertainment control unit, a stationary gaming console, smart television, a vehicle control unit, a digital camera, a digital video recorder, a wearable electrical device or an embedded computing system (e.g., computing systems that are part of a vehicle, smart home appliance, consumer electronics product or equipment, manufacturing equipment). In some embodiments, the electrical device 1700 may be any other electronic device that processes data. In some embodiments, the electrical device 1700 may comprise multiple discrete physical components. Given the range of devices that the electrical device 1700 can be manifested as in various embodiments, in some embodiments, the electrical device 1700 can be referred to as a computing device or a computing system.

While at least one embodiment has been presented in the foregoing detailed description, it should be appreciated that a vast number of variations exist. It should also be appreciated that the disclosed embodiments are only examples, and are not intended to limit the scope, applicability, or configuration of the disclosure in any way. Rather, the foregoing detailed description will provide those skilled in the art with a convenient road map for implementing the disclosed embodiment embodiments. Various changes can be made in the function and arrangement of elements without departing from the scope of the disclosure as set forth in the appended claims and the legal equivalents thereof.

As used herein, phrases such as "an embodiment," "various embodiments," "some embodiments," and the like, indicate that some embodiments may have some, all, or none of the features described for other embodiments. "First," "second," "third," and the like describe a common object and indicate different instances of like objects being referred to; unless specifically stated, they do not imply a given sequence, either temporally or spatially, in ranking, or any other manner. In accordance with patent application parlance, "connected" indicates elements that are in direct physical or electrical contact with each other and "coupled" indicates elements that cooperate or interact with each other, coupled elements may or may not be in direct physical or electrical contact. Furthermore, the terms "comprising," "including," "having," and the like, are utilized synonymously to denote non-exclusive inclusions.

As used herein, the terms "processor unit", "processing unit" or "processor" may refer to any device or portion of a device that processes electronic data from registers and/or memory to transform that electronic data into other electronic data that may be stored in registers and/or memory. A processor unit may be a system-on-a-chip (SOC), and/or include one or more digital signal processors (DSPs), application-specific integrated circuits (ASICs), central processing units (CPUs), graphics processing units (GPUs), general-purpose GPUs (GPGPUs), accelerated processing units (APUs), field-programmable gate arrays (FPGAs), neural network processing units (NPUs), data processor units (DPUs), accelerators (e.g., graphics accelerator, compression accelerator, artificial intelligence accelerator), controller cryptoprocessors (specialized processors that execute cryptographic algorithms within hardware), server processors, controllers, or any other suitable type of processor units. As such, the processor unit can be referred to as an XPU (or xPU).

As used herein, the term "electronic component" can refer to an active electronic circuit (e.g., a processing unit, a memory, a storage device, a field effect transistor (FET)) or a passive electronic component (e.g., resistor, inductor, capacitor).

As used herein, the term "integrated circuit component" can refer to an electronic component configured on a semiconducting material to perform a function. An integrated circuit (IC) component can comprise one or more of any computing system components described or referenced herein or any other computing system component, such as a processor unit, I/O controller, memory, or network interface controller, and can comprise one or more additional active or passive devices such as capacitors, decoupling capacitors, resistors, inductors, fuses, diodes, transformers, sensors, electrostatic discharge (ESD) devices, and memory devices.

A non-limiting example of an unpackaged integrated circuit component includes a single monolithic integrated circuit die (also shortened herein to "die"); the die may include solder bumps attached to contacts on the die. When present on the die, the solder bumps or other conductive contacts can enable the die to be directly attached to a printed circuit board (PCB) or other substrates.

A non-limiting example of a packaged integrated circuit component comprises one or more integrated circuit dies mounted on a package substrate with the integrated circuit dies and package substrate encapsulated in a casing material, such as a metal, plastic, glass, or ceramic. Often the casing includes an integrated heat spreader (IHS) component; the packaged integrated circuit component often has bumps, leads, or pins attached to the package substrate (either directly or by wires attaching the bumps, leads, or pins to the package substrate) for attaching the packaged integrated circuit component to a printed circuit board (or motherboard or base board) or another component.

As used in this application and the claims, a list of items joined by the term "at least one of" can mean any combination of the listed terms. For example, the phrase "at least one of A, B and C" can mean A; B; C; A and B; A and C; B and C; or A, B, and C. Similarly, as used in this application and the claims, a list of items joined by the term "one or more of" can mean any combination of the listed terms. For example, the phrase "one or more of A, B and C" can mean A; B; C; A and B; A and C; B and C; or A, B, and C.

The disclosed methods, apparatuses, and systems are not to be construed as limiting in any way. Instead, the present disclosure is directed toward all novel and nonobvious features and aspects of the various disclosed embodiments, alone and in various combinations and subcombinations with one another. The disclosed methods, apparatuses, and systems are not limited to any specific aspect or feature or combination thereof, nor do the disclosed embodiments require that any one or more specific advantages be present, or problems be solved.

Theories of operation, scientific principles, or other theoretical descriptions presented herein in reference to the apparatuses or methods of this disclosure have been provided for the purposes of better understanding and are not intended to be limiting in scope. The apparatuses and methods in the appended claims are not limited to those apparatuses and methods that function in the manner described by such theories of operation.

The following Examples pertain to additional embodiments of technologies disclosed herein.

### EXAMPLES

Example 1 is an integrated circuit structure, including: a cell on a metal level, the cell defined by a cell boundary; two or more substantially parallel signal traces inside the cell boundary, the two or more substantially parallel signal traces having a first width near the cell boundary; wherein at least one of the two or more substantially parallel signal traces has a region of a second width inside and away from the cell boundary (in the middle), the second width being at least 1.5 times as wide as the first width, plus or minus 10%.

Example 2 includes the subject matter of Example 1, further comprising: block-level routing interconnects arranged at a minimum pitch associated with the metal level around the cell boundary; and wherein individual signal traces of the two or more signal traces are colinear near the cell boundary with a respective one of the block-level routing interconnects.

Example 3 includes the subject matter of Example 1 or Example 2, further comprising: an arrangement of transistors below the metal level, the arrangement of transistors comprising: a first type of transistor formed in a first diffusion region extending in a first direction; a second type of transistor formed in a second diffusion region extending in the first direction; wherein individuals of the first type of transistors are operationally coupled to a respective second type of transistor to thereby define an output node; and the output node is coupled to the region of the second width.

Example 4 includes the subject matter of Example 3, further comprising a power delivery network (PDN) below the arrangement of transistors, the PDN coupled to the transistors in the arrangement of transistors with deep boundary vias.

Example 5 includes the subject matter of any one of Examples 1-4, wherein the metal level is referred to as metal 0 (M0) level and further comprising: a second metal level referred to as metal 1 (M1) above the M0 level within the cell boundary, the M1 level comprising one or more M1 traces that have a width that is at least 1.5 times the first width, plus or minus 10%; a via referred to as a via0 to electrically couple a M1 trace to the output node; and wherein the via0 has a width that is at least 1.5 times the first width, plus or minus 10%.

Example 6 includes the subject matter of Example 5, wherein the via0 further has a height that is at least 1.5 times the first width, plus or minus 10%.

Example 7 includes the subject matter of any one of Examples 1-3, further comprising a power delivery network (PDN) below the arrangement of transistors, the PDN coupled to the transistors in the arrangement of transistors with epitaxial through emerald vias (EMR).

Example 8 is a logic device, comprising: a plurality of cells arranged in a pattern and coupled together with block-level routing; and a backside power delivery network (PDN) beneath the plurality of cells and operationally coupled to the plurality of cells; wherein at least one cell of the plurality of cells individually comprises: a cell boundary; an arrangement of transistors within the cell boundary, the arrangement of transistors coupled together to generate an output signal at an output signal node that is a function of input signals received at one or more input signal nodes; a metal level above the arrangement of transistors, the metal level including one or more input signal traces and an output signal trace; wherein the output signal trace and the one or more input signal traces are substantially parallel inside the cell boundary and have a first width near the cell boundary; and wherein the output signal trace has a region of a second width inside the cell boundary, the second width being at least 1.5 times as wide as the first width, plus or minus 10%.

Example 9 includes the subject matter of Example 8, wherein the metal level is referred to as metal 0 (M0) level and wherein the at least one cell of the plurality of cells further comprises a metal one (M1) trace above the M0 level, the M1 trace has a width that is at least 1.5 times the first width, plus or minus 10%, coupled to the output node.

Example 10 includes the subject matter of Example 9, wherein the at least one cell of the plurality of cells further comprises: a via to electrically couple the M1 trace to the output signal trace; and wherein the via has a width that is at least 1.5 times the first width, plus or minus 10%.

Example 11 includes the subject matter of Example 10, wherein the via further has a height that is at least 1.5 times the first width, plus or minus 10%.

Example 12 includes the subject matter of Example 10, wherein the via is referred to as a via0, and wherein the at least one cell of the plurality of cells further comprises: a metal two (M2) trace above the M1 trace; and another via, referred to as a via1, that electrically couples the M1 trace to the M2 trace; and wherein the via1 has a width that is at least 1.5 times the first width, plus or minus 10%, and a height that is at least 1.5 times the first width, plus or minus 10%.

Example 13 includes the subject matter of Example 11, comprising a printed circuit board attached to the logic device.

Example 14 includes the subject matter of Example 13, comprising an integrated circuit (IC) die attached to the printed circuit board and electrically coupled to the logic device.

Example 15 includes the subject matter of Example 11, wherein the backside PDN is operationally coupled to the plurality of cells with boundary deep vias (DVB).

Example 16 includes the subject matter of Example 11, wherein the backside PDN is operationally coupled to the plurality of cells with epitaxial through emerald vias (EMR).

Example 17 is a method, comprising: generating, in a front end of line process on a semiconductor wafer, a cell comprising an arrangement of transistors in a device level, the arrangement of transistors having one or more input nodes, and an output node; wherein a cell boundary surrounds the arrangement of transistors; routing, in a back end of line process, a power delivery network (PDN) from a back side of the semiconductor wafer to the transistors in the device level; placing multiple metal zero (M0) traces across the cell, wherein the M0 traces are adjacent to and above the device level, and have a minimum metal zero (M0) pitch at the cell boundary; coupling a M0 trace to the output node; placing a metal one (M1) trace with a width that is at least 1.5 times the M0 pitch, plus or minus 10%, above the M0 trace; and coupling the M1 trace to the output node.

Example 18 includes the subject matter of Example 17, further comprising: coupling the M1 trace to the output node with a via; and wherein the via has the width that is at least 1.5 times the minimum M0 pitch, plus or minus 10%.

Example 19 includes the subject matter of Example 17, further comprising: creating, for the M0 trace that is coupled to the output node, a portion away from the cell boundary (near the middle) that is wide M0, wherein wide M0 is defined as M0 that is at least 1.5 times the minimum M0 pitch, plus or minus 10%.

Example 20 includes the subject matter of Example 17, further comprising implementing the PDN with boundary deep vias (DVB) or with epitaxial through emerald vias (EMR).

Example 21 includes the subject matter of Example 7, wherein the metal level is referred to as metal 0 (M0) level and further comprising: a second metal level referred to as metal 1 (M1) above the M0 level within the cell boundary, the M1 level comprising one or more M1 traces that have a width that is at least 1.5 times the first width, plus or minus 10%; a via referred to as a via0 to electrically couple a M1 trace to the output node; and wherein the via0 has a width that is at least 1.5 times the first width, plus or minus 10%.

Example 22 includes a motherboard, and the subject matter of any one of Examples 8-16 operationally coupled to the motherboard.

Example 23 includes the subject matter of Example 22 further comprising a power supply system operationally attached to the motherboard.

Example 24 is a consumer product, comprising the subject matter of any one of Examples 22-23, further comprising a housing at least partially surrounding the motherboard.

Example 25 is an electronic design automation tool configured to generate any one of Examples 1-16.

Example 25 is an electronic design automation tool configured to perform the tasks of any one of Examples 17-20.

Example 26 is a computer program that when executed by a processor, performs the tasks of any one of Examples 17-20.

Example 27 is a computer program that when executed by a processor, generates any one of the Examples 1-16.

## Claims

1. An integrated circuit structure, comprising:
a cell on a metal level, the cell defined by a cell boundary, and two or more substantially parallel signal traces inside the cell boundary, the two or more substantially parallel signal traces having a first width near the cell boundary;
wherein at least one of the two or more substantially parallel signal traces has a region of a second width inside and away from the cell boundary, the second width being at least 1.5 times as wide as the first width, plus or minus 10%.

2. The integrated circuit structure of claim 1, further comprising block-level routing interconnects arranged at a minimum pitch associated with the metal level around the cell boundary; wherein individual signal traces of the two or more signal traces are colinear near the cell boundary with a respective one of the block-level routing interconnects.

3. The integrated circuit structure of claim 1 or claim 2, further comprising:
an arrangement of transistors below the metal level, the arrangement of transistors comprising:
a first type of transistor formed in a first diffusion region extending in a first direction;
a second type of transistor formed in a second diffusion region extending in the first direction;
wherein individuals of the first type of transistors are operationally coupled to a respective
second type of transistor to thereby define an output node; and
the output node is coupled to the region of the second width.

4. The integrated circuit structure of claim 3, further comprising a power delivery network (PDN) below the arrangement of transistors, the PDN coupled to the transistors in the arrangement of transistors with deep boundary vias.

5. The integrated circuit structure of claim 3, wherein the metal level is referred to as metal 0 (M0) level and further comprising:
a second metal level referred to as metal 1 (M1) above the M0 level within the cell boundary, the M1 level comprising one or more M1 traces that have a width that is at least 1.5 times the first width, plus or minus 10%; and
a via referred to as a via0 to electrically couple a M1 trace to the output node;
wherein the via0 has a width that is at least 1.5 times the first width, plus or minus 10%.

6. The integrated circuit structure of claim 5, wherein the via0 further has a height that is at least 1.5 times the first width, plus or minus 10%.

7. The integrated circuit structure of any one of claim 5 or claim 6, wherein the cell is one of a plurality of cells arranged in a pattern and coupled together with block-level routing, and further comprising:
a backside power delivery network (PDN) beneath the plurality of cells and operationally coupled to the plurality of cells;
an arrangement of transistors within the cell boundary, the arrangement of transistors coupled together to generate an output signal at an output signal node that is a function of input signals received at one or more input signal nodes;
a metal level above the arrangement of transistors, the metal level including one or more input signal traces and an output signal trace; and
wherein the output signal trace and the one or more input signal traces are substantially parallel inside the cell boundary and have a first width near the cell boundary;
wherein the output signal trace has a region of a second width inside the cell boundary, the second width being at least 1.5 times as wide as the first width, plus or minus 10%.

8. The integrated circuit structure of claim 7, wherein the cell further comprises:
a metal two (M2) trace above the M1 trace; and
another via, referred to as a via1, that electrically couples the M1 trace to the M2 trace;
wherein the via1 has a width that is at least 1.5 times the first width, plus or minus 10%, and a height that is at least 1.5 times the first width, plus or minus 10%.

9. A method, comprising:
generating, in a front end of line process on a semiconductor wafer, a cell comprising an arrangement of transistors in a device level, the arrangement of transistors having one or more input nodes, and an output node;
wherein a cell boundary surrounds the arrangement of transistors;
routing, in a back end of line process, a power delivery network (PDN) from a back side of the semiconductor wafer to the transistors in the device level;
placing multiple metal zero (M0) traces across the cell, wherein the M0 traces are adjacent to and above the device level, and have a minimum metal zero (M0) pitch at the cell boundary;
coupling a M0 trace to the output node;
placing a metal one (M1) trace with a width that is at least 1.5 times the M0 pitch, plus or minus 10%, above the M0 trace; and
coupling the M1 trace to the output node.

10. The method of claim 9, further comprising:
coupling the M1 trace to the output node with a via;
wherein the via has the width that is at least 1.5 times the minimum M0 pitch, plus or minus 10%.

11. The method of claim 10, further comprising:
creating, for the M0 trace that is coupled to the output node, a portion that is wide M0, wherein
wide M0 is defined as M0 that is at least 1.5 times the minimum M0 pitch, plus or minus 10%.

12. The method of claim 11, further comprising implementing the PDN with boundary deep vias (DVB) or with epitaxial through emerald vias (EMR).

13. A logic device, comprising:
a plurality of cells arranged in a pattern and coupled together with block-level routing; and
a backside power delivery network (PDN) beneath the plurality of cells and operationally coupled to the plurality of cells;
wherein at least one cell of the plurality of cells individually comprises:
a cell boundary;
an arrangement of transistors within the cell boundary, the arrangement of transistors coupled together to generate an output signal at an output signal node that is a function of input signals received at one or more input signal nodes;
a metal level above the arrangement of transistors, the metal level including one or more input signal traces and an output signal trace; and
wherein the output signal trace and the one or more input signal traces are substantially parallel inside the cell boundary and have a first width near the cell boundary;
wherein the output signal trace has a region of a second width inside the cell boundary, the second width being at least 1.5 times as wide as the first width, plus or minus 10%.

14. The logic device of claim 13, wherein the metal level is referred to as metal 0 (M0) level and wherein the at least one cell of the plurality of cells further comprises a metal one (M1) trace above the M0 level, the M1 trace has a width that is at least 1.5 times the first width, plus or minus 10%, coupled to the output node.

15. The logic device of claim 14, wherein the at least one cell of the plurality of cells further comprises:
a via to electrically couple the M1 trace to the output signal trace;
wherein the via has a width that is at least 1.5 times the first width, plus or minus 10%.
